# EUROPEAN PATENT SPECIFICATION

(11) **EP 2 517 537 B1**
(45) Date of publication and mention of the grant of the patent: **03.04.2019**
(21) Application number: 10784454.0
(22) Date of filing: 24.11.2010
(51) Int. Cl.: H05B 33/10, C09K 11/06, H05B 33/20, H01L 51/56, H01L 51/00, H01L 51/50

(54) **ELECTROLUMINESCENT FUNCTIONAL SURFACTANTS**
FUNKTIONELLE ELEKTROLUMINESZENTE TENSIDE
SURFACTANTS FONCTIONNELS ÉLECTROLUMINESCENTS

(30) Priority: 22.12.2009 EP 09015862
(43) Date of publication of application: 31.10.2012
(73) Proprietor: Merck Patent GmbH, 64293 Darmstadt (DE)
(72) Inventor: PAN, Junyou, 60320 Fankfurt am Main (DE)
(86) International application number: PCT/EP2010/007133
(87) International publication number: WO 2011/076326

(56) References cited:
- WO-A2-2007/116363
- WO-A2-2008/104301
- WO-A2-2009/134822
- JP-A- 2003 332 600
- US-A1- 2008 299 295
- HUA ER, NORIE ASAOKA, NAOKO HISAMATSU, MASAYASU IIDA, TOYOKO IMAE: "Effects of metal-counterion interactions on the percolation in microemulsions composed of bis(N-octylethylenediamine)metal(II) complexes in water/benzene and water/chloroform systems", COLLOIDS AND SURFACES A: PHYSICOCHEMICAL AND ENGINEERING ASPECTS, vol. 221, 2003, pages 119-129, XP002620236,
- XU Z ET AL: "Surface and fluorescence properties of a novel fluorescent surfactant", COLLOIDS AND SURFACES. A, PHYSICACHEMICAL AND ENGINEERING ASPECTS, ELSEVIER, AMSTERDAM, NL, vol. 290, no. 1-3, 15 November 2006 (2006-11-15), pages 172-177, XP025136824, ISSN: 0927-7757, DOI: DOI:10.1016/J.COLSURFA.2006.05.024 [retrieved on 2006-11-15]
- SANTHAKUMAR K ET AL: "Metallomicelles of Co(III) coordination complexes - Synthesis, characterization and determination of CMC values", POLYHEDRON, PERGAMON PRESS, OXFORD, GB, vol. 25, no. 7, 8 May 2006 (2006-05-08), pages 1507-1513, XP024915977, ISSN: 0277-5387, DOI: DOI:10.1016/J.POLY.2005.08.054 [retrieved on 2006-05-08]

## Description

The present invention relates, inter alia, to functional surfactants, to formulations comprising them, to methods for their preparation, and the use of said formulations for the preparation of electronic or opto-electronic devices.

Organic electronics, such as organic light-emitting diodes (OLEDs), organic field-effect transistors (OFETs), organic photovoltaic cells (OPVs), organic light-emitting electro-chemical cells (OLECs) have drawn much attention in the past two decades, because they are versatile in material design, light-weight, and suitable for large area application. These organic electronic devices usually comprise a multilayer structure. Hereby it is crucial to deposit the active organic materials on the nano- to mesoscopic scale on a substrate. In addition, the formation of organic multilayer structures has to occur without affecting the underlying layers in an uncontrolled way. The development of cost effective technologies for the mass production of organic electronics will have a decisive role for their competitiveness as compared to current technologies employed. Cost reduction for the mass production is therefore a mandatory prerequisite for the commercial success of organic electronics. In order to achieve this goal solution based deposition methods could provide a solution. However, current technologies do not offer a competitive way to adequately prepare multilayered structures for organic electronics, particularly if they comprise small molecules. This is due to the fact that layers that have already been deposited may be, at least in part, dissolved or washed away when another layer is deposited on it.

In the case of OLEDs, the formation of patterned light emitting layers is an important but difficult step in the production of electroluminescent devices. For example, the formation of separate red, green and blue patterned emitter layers is typically required in the production of electroluminescent full color display devices. Vacuum evaporation (e.g., using a shadow mask) is the most common technique to form each of the patterned layers. However, vacuum evaporation techniques have a couple of drawbacks which may significantly inhibit the commercial development of multilayer structures comprising organic materials such as OLEDs. These techniques are rather complex in terms of equipment needed. In particular for large format displays, other methods for manufacturing patterned layers are needed. Methods based on depositing materials from solution are especially desirable for their expected compatibility with large scale device fabrication.

The possible technologies are, for example, ink-jet printing, dip coating, spin coating, letter-press printing, screen printing, doctor blade coating, and slot-die coating etc. Ink-jet printing is particularly preferred as it allows high resolution displays to be prepared. However, one has to find at first a suitable way to build a multilayer structure using these technologies. There are two known approaches to do this. The first one is to use a cross-linkable compound, as disclosed in EP 0637899 A1; here one first immobilises the first layer by cross linking induced either thermally or by exposure to (UV) light, before the next layer is coated or printed on that. The disadvantage of this approach is one has to introduce the cross-linkable compound in the layer, or even design the cross-linkable functional group in organic functional compounds; and moreover the residual cross-linkable group could also be harmful to the device performance. The second approach is to use so-called orthogonal solvents, e.g, the first layer is insoluble in the solvent of the solution, from which the second layer will be coated. To do so, one has to either have a pair of compounds, which are soluble in orthogonal solvents, or to find a suitable formulation, which fulfils the condition of orthogonal solvents.

One approach is disclosed in WO 2003/050147 A1 to prepare conjugated polymer dispersion from mini-emulsions, where the conjugated polymers are in form of small spherical units called semiconducting polymer nanospheres (SPNs). Miniemulsions are understood to be stable emulsions of droplets with a distinct size between 1 and 7000 nm, made by shearing a system containing a solvent A, a solution (in a solvent B) of a compound insoluble in solvent A, and a small amount of a surfactant, whereby solvent A is immiscible with solvent B. Polymer particles can be obtained from such droplets after evaporation of solvent A. The formulation of conjugated polymer in dispersion disclosed in WO 2003/050147 A1 can be used to build multilayer structures in, e.g. OLEDs and OPVs. The deposition of polymer is known in the prior art.

However, the performance of OLEDs based on small molecules (SMOLEDs) is in most cases much better as compared to OLEDs based on conjugated polymers (PLEDs). PLEDs suffer, for instance, from insufficient lifetime. On the other hand, recently the SMOLEDs have shown excellent performance, in aspects of color, lifetime and driving voltages. Actually, SMOLEDs has already achieved commercial entry into small display market, like mobile phone. In order to overcome the disadvantages of the thermal vacuum deposition which leads to a low material exploitation and to limited device dimension, the present invention relates to a method to formulate particularly small molecular compounds in miniemulsions and dispersions for facilitating the formation of a multilayer structure.

Miniemulsions comprising a continuous phase comprising a first solvent, a discontinuous phase comprising a second solvent and a surfactant, where the discontinuous phase comprises one organic functional material are disclosed in WO 2009/134822. Usually a surfactant is required to stabilize the miniemulsion or dispersion. The surfactants used in the prior art, e.g. sodium dodecyl sulphate, are, however, electronically inactive. Such kind of inactive compounds are highly undesired in electronic and opto-electronic devices like OLEDs or OPVs. Mobile ions like Na⁺, which is found in SDS, can be harmful for the device performance. The unwanted surfactant may be partly removed by different techniques, but at least traces of the surfactant are left in the device. It is therefore highly desirable to find another way to stabilize the miniemulsions and dispersions.

It is an object of the present invention to overcome the problems known in the prior art. In particular, it is an object of the present invention to provide emulsions and dispersions, methods for their preparations and their use for the preparation of electronic and opto-electronic devices, particularly those with a multilayer structure.

Surprisingly, it has been found that emulsions and dispersions comprising functional surfactants with beneficial manufacturing properties and opto-electronic properties can be formed. These emulsions and dispersions, commonly referred herein to as formulations, can be employed in order to prepare devices with layer and multilayer structures by using simple deposition techniques from solution. The formulations according to the present invention are particularly important and useful for the preparation of opto-electronic devices such as OLEDs, solar cells, and photovoltaic cells.

In a general embodiment, the present invention opens one new dimension to control the distribution of the components, allowing higher flexibility in solution or device preparation and new possibilities to form new micro- or nano-structures by integrating the functional component into the surfactant.

The general distinction between emulsion and dispersion is up to the composition of one or more of the discontinuous phases. An emulsion comprises, in addition to the functional materials, which are defined below, at least one solvent. If the solvent is removed a dispersion is obtained. The discontinuous phase of the formulation can exist in the form of a nanodroplet and nanoparticle in the case of an emulsion and dispersion, respectively.

The present invention relates to a formulation, which is an emulsion for the preparation of OLEDs comprising at least one continuous phase, which comprises a first solvent selected from water, alcohols, glycols, ethers and glycol ethers, at least one discontinuous phase, which comprises a second solvent selected from organic solvents with a lower polarity than the first solvent, and at least one functional surfactant, characterized in that the functional surfactant has the general Formula (1): 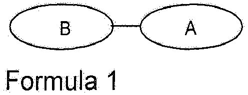 where
- A: is selected from the groups of Formulae 3 to 8, 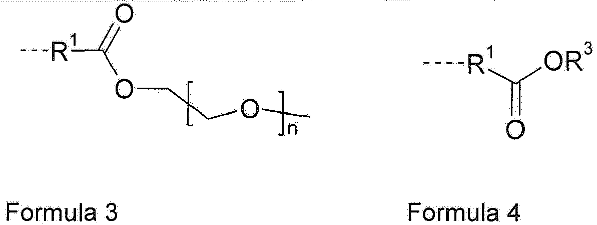 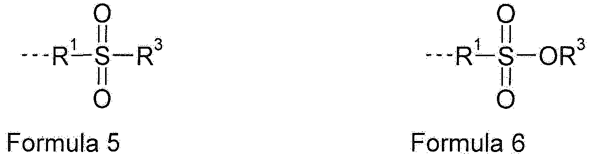 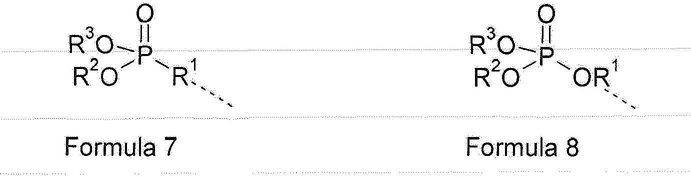
where
- R¹: is a substituted or unsubstituted hydrocarbyl group having 1 to 40 C atoms, which optionally comprises one or more hetero atoms;
- R², R³: are, identically or differently, selected from H, halogen, -CN, -NC,-NCO, -NCS, -OCN, -SCN, -C(=O)NR⁰R⁰⁰, -C(=O)X, -C(=O)R⁰,-NH₂, -NR⁰R⁰⁰, -SH, -SR⁰, -SO₃H, -SO₂R⁰, -OH, -NO₂, -CF₃, -SF₅, optionally substituted with hydrocarbyl having 1 to 6 C atoms, optionally comprising one or more hetero atoms;
- R⁰ and R⁰⁰: are independently of each other H or an optionally substituted hydrocarbyl group, optionally comprising one or more hetero atoms; and
- n: is equal or larger than 1;
- B: is a functional group, wherein the functional group is selected from host groups selected from oligoarylenes containing naphthalene, anthracene, benzanthracene and/or pyrene;
and wherein the emulsion comprises in the discontinuous phase at least one further organic functional material selected from host materials, hole injection materials (HIM), hole transport materials (HTM), hole blocking materials (HBM), electron injection materials (EIM), electron transport materials (ETM), electron blocking materials (EBM), exciton blocking materials (ExBM), photoabsorption materials, dyes, and metal complexes,
and wherein the discontinuous phase(s) form(s) nanodroplets.

The term functional groups refers to organic functional groups selected from organic conductors, organic semiconductors, organic dyes, organic fluorescent compounds, organic phosphorescent compounds, organic photoabsorbing compounds, organic photosensing compounds, organic photo sensitizer and other organic photocactive compounds. The term organic functional groups also includes organo-metallic complexes of transition metals, rare earths, lanthanides and actinides.

Examples of functional groups are host groups, emitter groups, hole injection groups, hole transport groups, hole blocking groups, electron injection groups, electron transport groups, electron blocking groups, exciton blocking groups, photoabsorption groups, dye groups, and metal complexes.

The organic functional group can be selected from the group of small molecules, polymers, oligomers, or dendrimers, blends or mixtures thereof.

The functional groups can be selected from groups and/or materials as outlined below for further functional materials. Preferably, the functional surfactant is a functionalized by a further functional material, wherein the term further functional material is defined below.

The functional surfactant also comprises a group facilitating the formation of the formulation. Facilitation the formation of a formulation also includes the stabilization of the already formed formulation.

The functional surfactant has an amphiphilic nature. Thus the components, i.e. functional group and the group facilitating the formation and stabilisation of the formulation have preferably different polarity or at least parts of their molecular structure have different polarity.

The functional surfactants according to the present invention have the general Formulae 1, 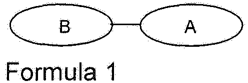 wherein A and B are as described above.

Some examples of functional surfactants are listed as follows:

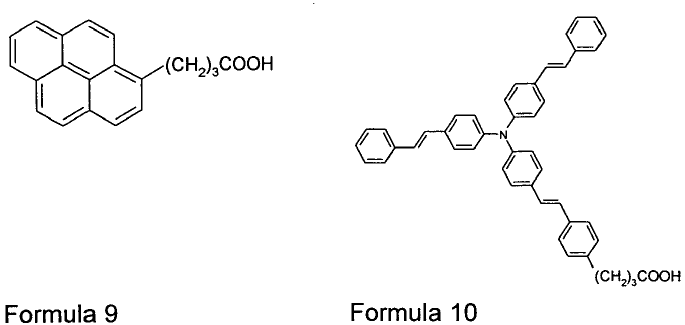

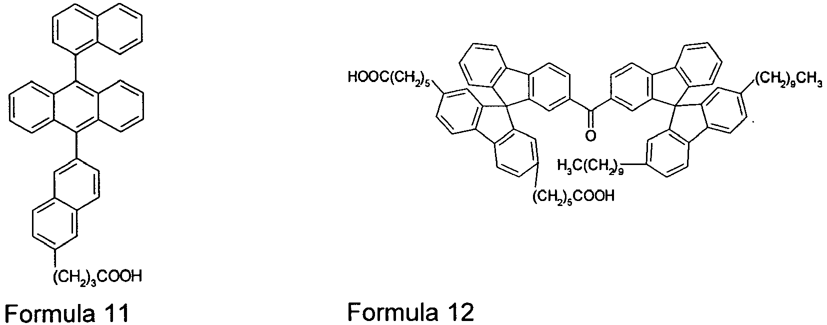

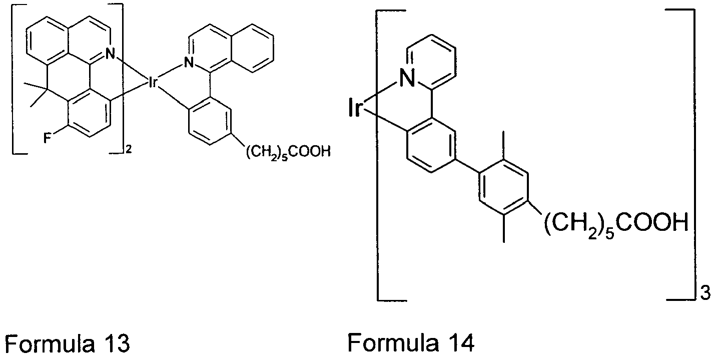

In principle a plurality of functional surfactants can be present in both the discontinuous phases and the continuous phases of the formulations of the present invention. Preferably the formulation according to the present invention comprises 3, particularly preferably 2, and very particularly preferably 1 functional surfactants.

Preferably the formulation comprises 3, particularly preferably 2, and very particularly preferably 1 continuous phase.

Preferably the formulation comprises 3, particularly preferably 2, and very particularly preferably 1 discontinuous phase.

Particular preference is given to a formulation comprising one continuous and one discontinuous phase.

In another preferred embodiment the formulation comprises one continuous phase and two discontinuous phases.

The formulation according to the invention may be an oil-in-water emulsion (normal emulsion).

Moreover, the formulation according to the invention may be a water-in-oil emulsion (inverse emulsion).

Suitable alcohols are alcohols which 1) are in liquid form at working temperature, and 2) have a boiling point below 200°C, so that it could be removed by heating after the formulation is coated, and 3) if together with water as solvent, are miscible with water, preferably having a solubility in water of more than 2 g/L. The said working temperature means the temperature, at which the formulation is prepared, preferably at room temperature. More details on alcohols can be found in textbooks of organic chemistry or suitable handbooks. Preferred alcohols are for example, but not limited to, alcohols with 1 to 12 C-atoms having a linear or branched alkyl chain, such as methanol, ethanol, iso-propanol, n-propanol, 1-propanol, 2-propanol, 1-butanol, 2-methyl-1-propanol, 2-butanol, 2-methyl-2-propanol, 1-pentanol, 2-methyl-1-butanol, 3-methyl-1-butanol, n-butanol, isobutanol, 1-pentanol, isoamyl alcohol, 2-methyl-1-butanol, neopentyl alcohol, 3-pentanol, 2-pentanol, 3-methyl-2-butanol, and 2-methyl-2-butanol.

In a preferred embodiment of the present invention the concentration of continuous phase in the formulation is in an amount ranging from 10 to 99 wt%, preferably from 20 to 95 wt%, particularly preferably from 40 to 95 wt%, very particularly preferably from 50 to 95 wt%.

In another preferred embodiment the said mixture of at least two organic solvents may comprise 2, 3, 4, 5 or more organic solvents.

Suitable organic solvents comprise ketones, esters, amides, sulphur compounds, nitro compounds, halogenated hydrocarbons and hydrocarbons. Aromatic and heteroaromatic hydrocarbons and chlorinated hydrocarbons are preferred organic solvents.

Particularly preferred organic solvents are, for example, dichloromethane, trichloromethane, monochlorobenzene, o-dichlorobenzene, tetrahydrofuran, anisole, morpholine, toluene, chroloform, o-xylene, m-xylene, p-xylene, 1,4-dioxane, acetone, methylethylketone, 1,2-dichloroethane, 1,1,1-trichloroethane, 1,1,2,2-tetrachloroethane, ethyl acetate, n butyl acetate, dimethylformamide, dimethylacetamide, dimethylsulfoxide, tetralin, decalin, indane and/or mixtures thereof.

In a preferred embodiment either said continuous phase and/or said discontinuous phase comprise(s) further additive to reduce the surface tension, or to improve the film formation. The suitable additive can be preferably referred to, e.g., WO 2003/019693 A2

The formulation according to the present invention can additionally comprise one or more further components like for example surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, or inhibitors.

In another subject of the present invention the formulation, if the formulation is an emulsion, is characterized in that the discontinuous phase forms nanodroplets having an average diameter in the range of 1 to 7000 nm, preferably in the range of 1 to 3000 nm, particularly preferably in the range of 5 to 2000 nm, and very particularly preferably in the range of 5 to 1000 nm.

A miniemulsion is characterized in that the average diameter of the nanodroplets is in the range between 1 and 7000 nm, preferably between 10 to 2000 nm, particularly preferably between 10 to 500 nm, very particularly preferably between 10 to 300 nm, and still more very particularly preferably between 20 and 100 nm. The term emulsion as used herein refers to, depending on the average size of the nanodroplets, both emulsions and miniemulsions.

A dispersion is characterized in that the discontinuous phase forms nanoparticles having an average diameter in the range of 1 to 5000 nm, preferably in the range of 1 to 2000 nm, particularly preferably in the range of 5 to 500 nm, and very particularly preferably in the range of 10 to 300 nm, still more very particularly preferably in the range of 20 to 100 nm.

In yet another embodiment of the present invention, the formulation, which is an emulsion, is characterized in that the discontinuous phase forms nanodroplets, wherein more than 75% of the nanodroplets, preferably more than 80%, particularly preferably more than 90%, and very particularly preferably more than 98% have an average diameter that deviates from the mean of all average diameters of the nanodroplets by 55% or less, preferably 50% or less, particularly preferably 20% or less, and very particularly preferably 10% or less.

The size and size distribution of nanodroplets can be measured by employing standard techniques known to one skilled in the art. Dynamic light scattering can be used to measure both parameters (Chu, B. Laser Light scattering: Basic Principles and Practice, 2nd Edition. Academic Press (1992)).

Preferably the formulation according to the present invention comprise 3, particularly preferably 2, and very particularly preferably 1 further functional material.

The further functional materials can be present in either the continuous phase(s), the discontinuous phase(s) or in both types of phases.

The emitter materials are preferably selected from the class of organic electroluminescent emitter materials as outlined elsewhere within the present invention. The dyes are preferably selected from compounds employed in conjunction with organic solar cells, organic photovoltaic cells, and dye-sensitized solar cells as described below.

The further functional material can be selected from small molecules, polymers, oligomers, or dendrimers, blends or mixtures thereof.

The term small molecule as used herein is defined as molecule not being a polymer, oligomer, dendrimer, or a blend. In particular, repeating structures are absent in small molecules. The molecular weight of small molecules is typically in the range of polymers with a low number of repeating units, oligomers or less.

The molecular weight of the small molecule is preferably below 5000 g/mol, particularly preferably below 3000 g/mol, and very particularly preferably below 2000 g/mol.

The polymers of the present invention preferably have 10 to 10000, particularly preferably 20 to 5000 and very particularly preferably 50 to 2000 repeat units. Oligomers according to this invention have preferably 2 to 9 repeat units. The branching index of the polymers and oligomers is between 0 (linear polymer without branching) and 1 (completely branched dendrimer). The term dendrimer as used herein is defined according to M. Fischer et al. in Angew. Chem., Int. Ed. 1999, 38, 885).

The molecular weight (MW) of the polymers of the present invention is preferably in the range of 10000 to 2000000 g/mol, particularly preferably in the range of 100000 to 1500000 g/mol, and very particularly preferably in the range of 200000 to 1000000 g/mol. The determination of MW can be performed according to standard techniques known to the person skilled in the art by employing gel permeation chromatography (GPC) with polystyrene as internal standard, for instance.

A blend is a mixture comprising at least one polymeric dendrimeric, or oligomeric component.

The further functional materials and the functional groups of the functional surfactant, commonly herein referred to as functional materials, are often characterized by their molecular frontier orbitals, i.e. the highest occupied molecular orbital (HOMO) (sometimes also referred to as valence band) and the lowest unoccupied molecular orbital (LUMO)(sometimes also referred to as conduction band). The HOMO and LUMO levels are routinely measured (by e.g. XPS = X-ray photoelectron spectroscopy, UPS=ultra-violet photoelectron spectroscopy or CV=cyclovoltammetry) or calculated (by quantum chemical methods such as (time dependent) DFT= density functional theory) which are known to the person skilled in the art. One skilled in the art is also aware of the fact that absolute values of these energy levels significantly depend on the method used. The applicants established a consistent combination method to determine the energy levels of organic semiconductors. The HOMO/LUMO levels of a set of semiconductors (more than 20 different semiconductors) are measured by CV with a reliable evaluation method and also calculated by the DFT of Gaussian 03W with the same correction functional, for example B3PW91 and the same basis set, for example 6-31 G(d). The calculated values are then calibrated according to the measured values. Such calibration factor is used for further calculation. The agreement between calculated and measured values is very good. Therefore, the comparison of the energy levels of this invention is set on a sound base. The energy gaps or band gaps are obtained by the difference between HOMO and LUMO energy levels.

The formulations according to the invention may comprise one or more functional materials selected from hole injection materials (HIM). A HIM refers to a material or unit capable of facilitating holes (i.e. positive charges) injected from an anode into an organic layer or an anode. Typically, a HIM has a HOMO level comparable to or higher than the work function of the anode, i.e. - 5.3 eV or higher.

The formulations according to the invention may comprise one or more functional materials selected from hole transport materials (HTM). A HTM is characterized in that it is a material or unit capable of transporting holes (i.e. positive charges) injected from a hole injecting material or an anode. A HTM has usually high HOMO, typically higher than -5.4 eV. In many cases, HIM can functions also as HTM, depending on the adjacent layer.

The formulations according to the invention may comprise one or more functional materials selected from hole blocking materials (HBM). A HBM refers to a material which, if deposited adjacent to an emissive layer or a hole transporting layer in a multilayer structure, prevents the holes flowing through. Usually it has a lower HOMO as compared to the HOMO level of the HTM in the adjacent layer. Hole-blocking layers are frequently inserted between the light-emitting layer and the electron-transport layer in OLEDs.

The formulations according to the invention may comprise one or more functional materials selected from electron injection materials (EIM). An EIM refers to a material capable of facilitating electrons (i.e. negative charges) injected from cathode into an organic layer. The EIM usually has a LUMO level comparable to or lower than the working function of cathode. Typically, the EIM has a LUMO lower than -2.6 eV.

The formulations according to the invention may comprise one or more functional materials selected from electron transport materials (ETM). An ETM refers to a material capable of transporting electrons (i.e. negative charges) injected from an EIM or a cathode. The ETM has usually a low LUMO, typically lower than -2.7 eV. In many cases, an EIM can serve as ETM as well, depending on the adjacent layer.

The formulations according to the invention may comprise one or more functional materials selected from electron blocking materials (EBM). An EBM refers to a material which, if deposited adjacent to an emissive or electron transporting layer in a multilayer structure, prevents the electron flowing through. Usually it has a higher LUMO as compared to the LUMO of the ETM in the adjacent layer.

The formulations according to the invention may comprise one or more functional materials selected from exciton blocking materials (ExBM). An ExBM refers to a material which, if deposited adjacent to an emissive layer in a multilayer structure, prevents the excitons diffuse through. ExBM should have either a higher triplet level or singlet level as compared to the emissive layer or other adjacent layer.

The formulations according to the invention may comprise one or more functional materials selected from emitters. The term emitter refers to a material which, upon receiving excitonic energy by any kind of energy transfers from other materials, or by forming an exciton either electrically or optically, undergoes radiative decay to emit light. There are two classes of emitters, fluorescent and phosphorescent emitters. The term fluorescent emitter relates to materials or compounds which undergo a radiative transition from an excited singlet state to its ground. The term phosphorescent emitter, as used herein, relates to luminescent materials or compounds which comprise transition metals. This typically includes materials emitting light caused by spin forbidden transition(s), e.g., transitions from excited triplet states.

The term dopant as employed herein is also used for the term emitter or emitter material.

The formulations according to the invention may comprise one or more functional materials selected from host materials. Host materials are usually used in combination with emitter and have, in general, larger energy gaps between the HOMO and the LUMO as compared to emitter materials. In addition, host materials behave either as electron or hole transport material. Host materials can also have both electron and hole transport properties. In case singlet transitions are predominantly responsible for photoluminescence in OLEDs, a maximal overlap between the absorption spectrum of the emitter with the photoluminescence spectrum of the host material is highly desirably. This ensures the energy transfer from the host material to the emitter.

Host material is also called matrix or matrix material, particularly if a host is meant which is used in combination with a phosphorescent emitter in an OLEDs. And for copolymer, comprising emitter unit, the polymer backbone has the same mean as host.

The formulations according to the invention may comprise one or more functional materials selected from metal complexes. According to quantum mechanics the transition from excited states with high spin multiplicity, e.g. from excited triplet states, to ground state is forbidden.

However, the existence of an heavy atom, for example iridium, osmium, platinum and europium, results in a strong spin-orbit coupling, i.e. the excited singlet and triplet are mixed so that triplet gains some singlet character; and if singlet -triplet mixing yields a radiative decay rate faster than the non-radiative event, then the luminance can be efficient. This kind of emission can be achieved using metal complex, as firstly reported by Baldo et al.; Nature 395, 151-154 (1998). Further metal complexes can also function as efficient and broad-band light absorbing materials or dyes, as for example Ru complex reported by B. O'Regan & M. Graetzel, Nature 353, 737 (1991).

The formulations according to the invention may comprise one or more functional materials selected from dyes. A dye can generally be described as an inorganic or organic substance that absorbs light and, therefore, appears colored. The definition of dyes as light absorbing materials which harvest light in order to transmit the light energy to further materials either as light or in any other kind of converted energy.

Further to HIMs mentioned elsewhere herein, suitable HIMs are phenylenediamine derivatives (US 3615404), arylamine derivatives (US 3567450), amino-substituted chalcone derivatives (US 3526501), styrylanthracene derivatives (JP Showa 54 (1979) 110837), hydrazone derivatives (US 3717462), acylhydrazones, stilbene derivatives (JP Showa 61 (1986) 210363), silazane derivatives (US 4950950), polysilane compounds (JP Heisei 2 (1990) 204996), PVK and other electrically conductive macromolecules, aniline-based copolymers (JP Heisei 2 (1990) 282263), electrically conductive, macromolecular thiophene oligomers (JP Heisei 1 (1989) 211399), PEDOT:PSS (spin-coated polymer), plasma-deposited fluorocarbon polymers (US 6127004, US 6208075, US 6208077), porphyrin compounds (JP Showa 63 (1988) 2956965, US 4720432), aromatic tertiary amines and styrylamines (US 4127412), triphenylamines of the benzidine type, triphenylamines of the styrylamine type, and triphenylamines of the diamine type. Arylamine dendrimers can also be used (JP Heisei 8 (1996) 193191), as can phthalocyanine derivatives, naphthalocyanine derivatives, or butadiene derivatives, are also suitable.

Preferably, the HIM is selected from monomeric organic compound comprising amine, triarylamine, thiophene, carbazole, phthalocyanine, porphyrine and their derivatives.

Particular preference is given to the tertiary aromatic amines (US 2008/0102311 A1), for example N,N'-diphenyl-N,N'-di(3-tolyl)-benzidine (= 4,4'-bis[N-3-methylphenyl]-N-phenylamino)biphenyl (NPD) (US 5061569), N,N'-bis(N,N'-diphenyl-4-aminophenyl)-N,N-diphenyl-4,4'-diamino-1,1'-biphenyl (TPD 232) and 4,4',4"-tris[3-methylphenyl)phenyl-amino]-triphenylamine (MTDATA) (JP Heisei 4 (1992) 308688) or phthalocyanine derivatives (for example H2Pc, CuPc, CoPc, NiPc, ZnPc, PdPc, FePc, MnPc, ClAlPc, ClGaPc, ClInPc, ClSnPc, Cl2SiPc, (HO)AlPc, (HO)GaPc, VOPc, TiOPc, MoOPc, GaPc-O-GaPc).

Particular preference is given to the following triarylamine compounds of the Formulae 15 (TPD 232), 16, 17, and 18, which may also be substituted, and further compounds as disclosed in US 7399537 B2, US 2006/0061265 A1, EP 1661888 A1, and JP 08292586 A. Further compounds suitable as hole injection material are disclosed in EP 0891121 A1 and EP 1029909 A1. Hole injection layers in general are described in US 2004/0174116.

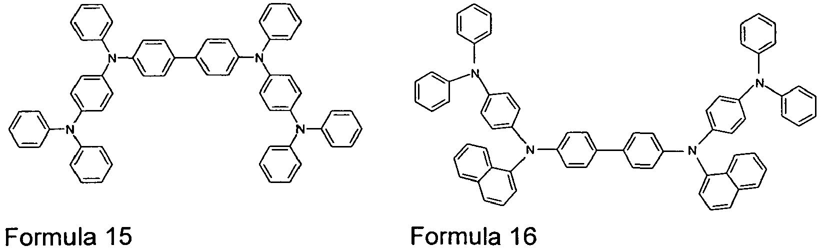

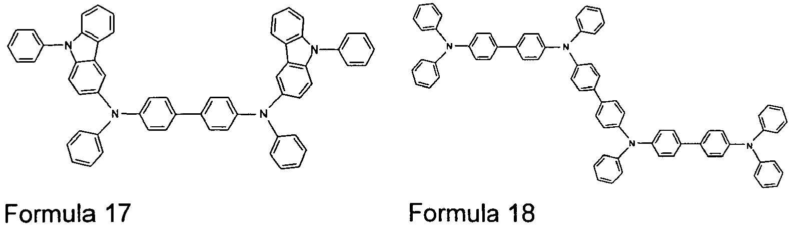

In principle any HTM known to one skilled in the art can be employed in formulations according to the present invention. Further to HTM mentioned elsewhere herein, HTM is preferably selected from amines, triarylamines, thiophenes, carbazoles, phthalocyanines, porphyrines, isomers and derivatives thereof. HTM is particularly preferably selected from amines, triarylamines, thiophenes, carbazoles, phthalocyanines, and porphyrines.

Suitable materials for hole-transporting layers are phenylenediamine derivatives (US 3615404), arylamine derivatives (US 3567450), amino-substituted chalcone derivatives (US 3526501), styrylanthracene derivatives (JP A 56-46234), polycyclic aromatic compounds (EP 1009041), polyarylalkane derivatives (US 3615402), fluorenone derivatives (JP A 54-110837), hydrazone derivatives (US 3717462), stilbene derivatives (JP A 61-210363), silazane derivatives (US 4950950), polysilanes (JP A 2-204996), aniline copolymers (JP A 2-282263), thiophene oligomers, polythiophenes, PVK, polypyrroles, polyanilines and further copolymers, porphyrin compounds (JP A 63-2956965), aromatic dimethylidene-type compounds, carbazole compounds, such as, for example, CDBP, CBP, mCP, aromatic tertiary amine and styrylamine compounds (US 4127412), and monomeric triarylamines (US 3180730). Even more triarylamino groups may also be present in the molecule. Preference is given to aromatic tertiary amines containing at least two tertiary amine units (US 4720432 and US 5061569), such as, for example, 4,4'-bis[N-(1-naphthyl)-N-phenylamino]biphenyl (NPD) (US 5061569) or MTDATA (JP A 4-308688), N,N,N',N'-tetra(4-biphenyl)diaminobiphenylene (TBDB), 1,1-bis(4-di-p-tolylaminophenyl)cyclohexane (TAPC), 1,1-bis(4-dip-tolylaminophenyl)-3-phenylpropane (TAPPP), 1,4-bis[2-[4-[N,N-di(p-tolyl)amino]phenyl]vinyl]benzene (BDTAPVB), N,N,N',N'-tetra-p-tolyl-4,4'-diaminobiphenyl (TTB), TPD, N,N,N',N'-tetraphenyl-4,4"'-diamino-1,1':4',1":4",1"'-quaterphenyl, likewise tertiary amines containing carbazole units, such as, for example, 4 (9H-carbazol-9-yl)-N,N-bis[4-(9H-carbazol-9-yl)phenyl]benzeneamine (TCTA). Preference is likewise given to hexaazatriphenylene compounds in accordance with US 2007/0092755 A1.

Particular preference is given to the following triarylamine compounds of the Formulae 19 to 24, which may also be substituted, and as disclosed in EP 1162193 A1, EP 650955 A1, Synth. Metals 1997, 91(1-3), 209, DE 19646119 A1, WO 2006/122630 A1, EP 1860097 A1, EP 1834945 A1, JP 08053397 A, US 6251531 B1, and WO 2009/041635.

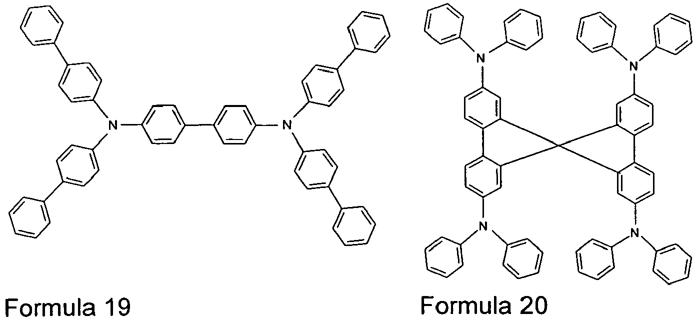

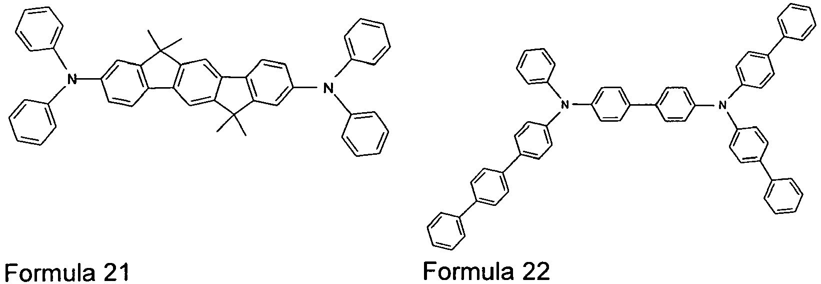

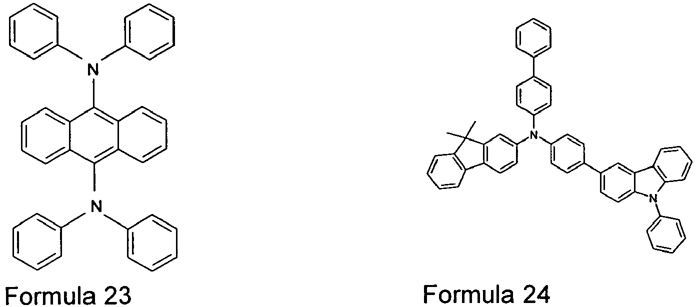

In principle any HBM known to one skilled in the art can be employed in formulations according to the present invention. Further to HBM mentioned elsewhere herein, suitable hole-blocking materials are metal complexes (US 2003/0068528), such as, for example, bis(2-methyl-8-quinolinolato)(4-phenylphenolato)-aluminium(III) (BAlQ). Fac-tris(1-phenylpyrazolato-N,C2)iridium(III) (Ir(ppz)₃) is likewise used for this purpose (US 2003/0175553 A1). Phenanthroline derivatives, such as, for example, BCP, or phthalimides, such as, for example, TMPP, are likewise employed.

Further, suitable hole-blocking materials are described in WO 00/70655 A2, WO 01/41512 and WO 01/93642 A1.

In principle any EIM known to one skilled in the art can be employed in formulations according to the present invention. Further to EIM mentioned elsewhere herein, suitable EIM elsewhere herein, ElMs, which comprises at least one organic compound selected from metal complexes of 8-hydroxyquinoline, heterocyclic organic compounds, fluorenones, fluorenylidene methane, perylenetetracarboxylic acid, anthraquinone dimethanes, diphenoquinones, anthrones, anthraquinonediethylenediamines, isomers and derivates thereof can be used according to the invention.

Metal complexes of 8 hydroxyquinoline, such as, for example, Alq₃ and Gaq₃, can be used as EIM for electron-injection layers. A reducing doping with alkali metals or alkaline-earth metals, such as, for example, Li, Cs, Ca or Mg, at the interface to the cathode is advantageous. Preference is given to combinations which include Cs, for example Cs and Na, Cs and K, Cs and Rb or Cs, Na and K.

Heterocyclic organic compounds, such as, for example, 1,10-phenanthroline derivatives, benzimidazoles, thiopyran dioxides, oxazoles, triazoles, imidazoles or oxadiazoles, are likewise suitable. Examples of suitable five-membered rings containing nitrogen are oxazoles, thiazoles, oxadiazoles, thiadiazoles, triazoles, and compounds which are disclosed in US 2008/0102311 A1.

Preferred ElMs are selected from compounds with the Formulae 25 to 27, which may be substituted or unsubstituted.

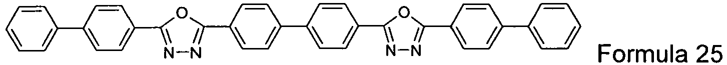

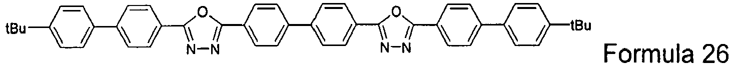

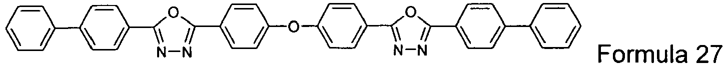

Organic compounds, such as fluorenones, fluorenylidene methane, perylenetetracarboxylic acid, anthraquinone dimethanes, diphenoquinones, anthrones and anthraquinonediethylenediamines, can also be employed, for example

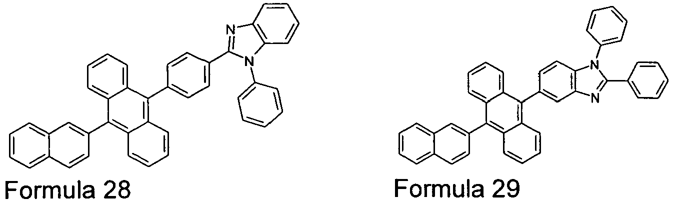

In principle any ETM known to one skilled in the art can be employed in formulations according to the present invention. Further to ETM mentioned elsewhere herein, suitable ETM is selected from imidazoles, pyridines, pyrimidines, pyridazines, pyrazines, oxadiazoles, chinolines, chinoxalines, anthracenes, benzanthracenes, pyrenes, perylenes, benzimidazoles, triazines, ketones, phosphinoxides, phenazines, phenanthrolines, triarylboranes, isomers and derivatives thereof.

Suitable ETMs for electron-transporting layers are metal chelates of 8 hydroxyquinoline (for example Liq, Alq₃, Gaq₃, Mgq₂, Znq₂, Inq₃, Zrq₄), Balq, 4 azaphenanthrene-5-ol/Be complexes (US 5529853 A; e.g. Formula 30), butadiene derivatives (US 4356429), heterocyclic optical brighteners (US 4539507), benzazoles, such as, for example, 1,3,5-tris(2-N-phenylbenzimidazolyl)benzene (TPBI) (US 5766779, Formula 31), 1,3,5-triazines, pyrenes, anthracenes, tetracenes, fluorenes, spirobifluorenes, dendrimers, tetracenes, for example rubrene derivatives, 1,10-phenanthroline derivatives (JP 2003/115387, JP 2004/311184, JP 2001/267080, WO 2002/043449), silacyl-cyclopentadiene derivatives (EP 1480280, EP 1478032, EP 1469533), pyridine derivatives (JP 2004/200162 Kodak), phenanthrolines, for example BCP and Bphen, also a number of phenanthrolines bonded via biphenyl or other aromatic groups (US 2007/0252517 A1) or phenanthrolines bonded to anthracene (US 2007/0122656 A1, e.g. Formulae 32 and 33), 1,3,4-oxadiazoles, for example Formula 34, triazoles, for example Formula 35, triarylboranes, for example also with Si (e.g. Formula 62), benzimidazole derivatives and other N heterocyclic compounds (cf. US 2007/0273272 A1), silacyclopentadiene derivatives, borane derivatives, Ga oxinoid complexes.

Preference is given to 2,9,10-substituted anthracenes (with 1- or 2-naphthyl and 4- or 3-biphenyl) or molecules which contain two anthracene units (US 2008/0193796 A1).

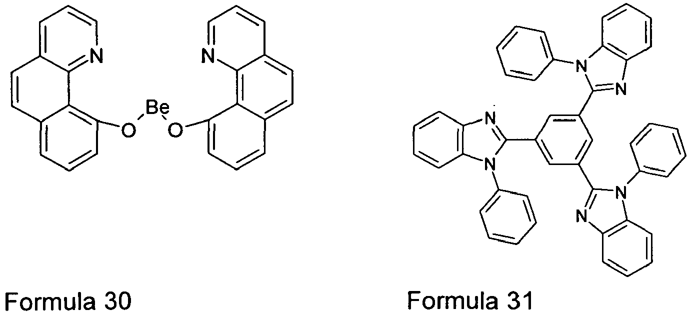

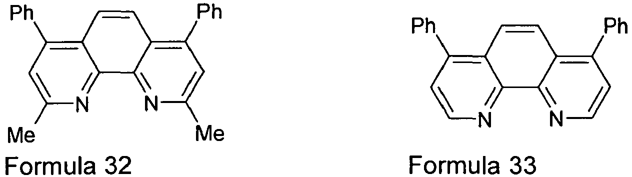

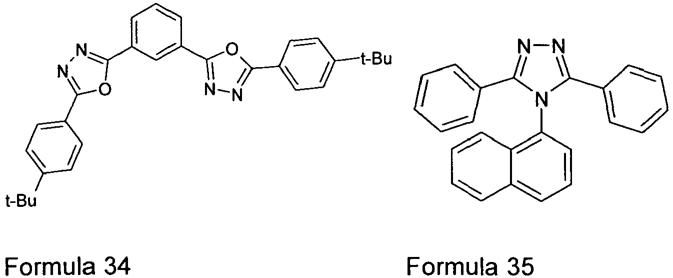

Preference is likewise given to anthracene-benzimidazole derivatives, such as, for example, the compounds of Formulae 36 to 38, and as disclosed in, e.g., US 6878469 B2, US 2006/147747 A, and EP 1551206 A1.

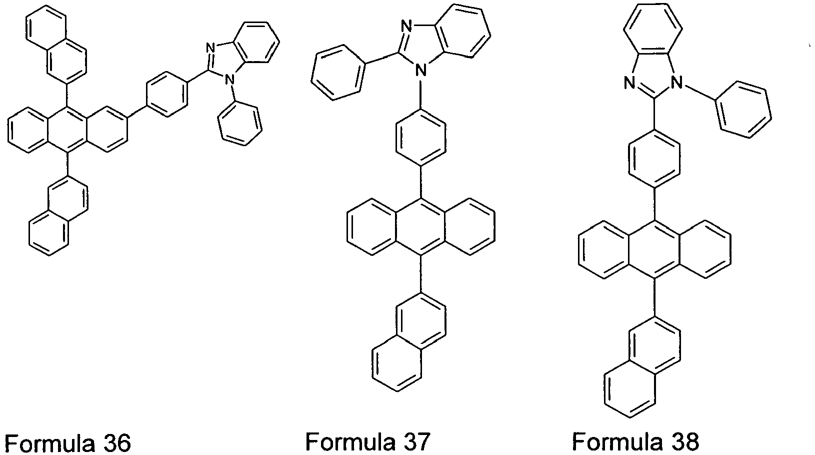

In principle any EBM known to one skilled in the art can be employed in formulations according to the present invention. Further to EBM mentioned elsewhere herein, transition-metal complexes, such as, for example, Ir(ppz)₃ (US 2003/0175553) can be employed as materials for an electron-blocking layer.

Preferably, the EBM is further selected from amines, triarylamines and their derivatives.

It is known to a person skilled in the art that the selection of ExBMs suitable for formulations according to the present invention depends on the energy gap of the adjacent layer. Suitable ExBMs are supposed to have a bigger energy gap, either singlet or triplet than the functional material in the adjacent layer which is preferably an emissive layer. Further to ExBMs mentioned elsewhere herein, substituted triarylamines, such as, for example, MTDATA or 4,4',4"-tris(N,N-diphenylamino)-triphenylamine (TDATA), can be used as ExBM for electron-blocking layers. Substituted triarylamines are described, for example, in US 2007/0134514 A1.

N-substituted carbazole compounds, such as, for example, TCTA, or heterocycles, such as, for example, BCP, are also suitable.

Metal complexes, such as, for example, Ir(ppz)₃ or Alq₃, can likewise be used for this purpose.

In principle any host material known to one skilled in the art can be employed in formulations according to the present invention. Depending on the kind of emitter employed host materials can be separated into two categories, hosts for fluorescent emitter and hosts for phosphorescent emitter, whereby the latter is often referred to as matrix or matrix material.

Formulations according to the present invention may also comprise more than one host material, preferably it comprises 3 host materials, particularly preferably it comprises 2 host materials, and very particularly preferably one host material. If aformulation according to this invention comprises at least two host materials, the host materials are also referred to as co-host or co-host materials.

Preferred host materials suitable for fluorescent emitter are selected from anthracenes, benzanthracenes, indenofluorenes, fluorenes, spirobifluorenes, phenanthrenes, dehydrophenanthrenes, thiophenes, triazines, imidazole and derivatives thereof.

Particularly preferred host materials for fluorescent emitter are selected from the classes of the oligoarylenes (for example 2,2',7,7'-tetraphenyl-spirobifluorene in accordance with EP 676461 or dinaphthylanthracene), in particular the oligoarylenes containing condensed aromatic groups, such as, for example, phenanthrene, tetracene, coronene, chrysene, fluorene, spirofluorene, perylene, phthaloperylene, naphthaloperylene, decacyclene, rubrene, the oligoarylenevinylenes (for example 4,4'-bis(2,2-diphenylethenyl)-1,1'-biphenyl (DPVBi) or 4,4-bis-2,2-diphenylvinyl-1,1-spirobiphenyl (spiro-DPVBi) in accordance with EP 676461), the polypodal metal complexes (for example in accordance with WO 2004/081017), in particular metal complexes of 8 hydroxyquinoline, for example aluminium(III) tris(8-hydroxyquinoline) (aluminium quinolate, Alq₃) or bis(2-methyl-8-quinolinolato)-4-(phenylphenolinolato)aluminium, also with imidazole chelate (US 2007/0092753 A1) and quinoline-metal complexes, aminoquinoline-metal complexes, benzoquinoline-metal complexes, the hole-conducting compounds (for example in accordance with WO 2004/058911), the electron-conducting compounds, in particular ketones, phosphine oxides, sulfoxides, etc. (for example in accordance with WO 2005/084081 and WO 2005/084082), the atropisomers (for example in accordance with WO 2006/048268), the boronic acid derivatives (for example in accordance with WO 2006/117052) or the benzanthracenes (e.g. DE 102007024850). Particularly preferred host materials are selected from the classes of the oligoarylenes, containing naphthalene, anthracene, benzanthracene and/or pyrene, or atropisomers of these compounds, the ketones, the phosphine oxides and the sulfoxides. Very particularly preferred host materials are selected from the classes of the oligoarylenes, containing anthracene, benzanthracene and/or pyrene, or atropisomers of these compounds. For the purposes of this invention, an oligoarylene is intended to be taken to mean a compound in which at least three aryl or arylene groups are bonded to one another.

Further preferred host materials for fluorescent emitter are selected, in particular, from compounds of the Formula 39

Ar⁴-(Ar⁵)ₚ-Ar⁶ Formula 39

wherein
Ar⁴, Ar⁵, Ar⁶ are on each occurrence, identically or differently, an aryl or heteroaryl group having 5 to 30 aromatic ring atoms, which may be substituted by one or more radicals and
p is 1, 2, or 3,
the sum of the π-electrons in Ar⁴, Ar⁵ and Ar⁶ is at least 30 if p = 1 and is at least 36 if p = 2 and is at least 42 if p = 3.

It is particularly preferred in the host materials of the Formula 39 for the group Ar⁵ to stand for anthracene, which may be substituted by one or more radicals R¹, and for the groups Ar⁴ and Ar⁶ to be bonded in the 9 and 10-positions. Very particularly preferably, at least one of the groups Ar⁴ and/or Ar⁶ is a condensed aryl group selected from 1- or 2-naphthyl, 2-, 3- or 9-phenanthrenyl or 2-, 3-, 4-, 5-, 6- or 7-benzanthracenyl, each of which may be substituted by one or more radicals R¹. Anthracene-based compounds are described in US 2007/0092753 A1 and US 2007/0252517 A1, for example 2-(4-methylphenyl)-9,10-di-(2-naphthyl)anthracene, 9-(2-naphthyl)-10-(1,1'-biphenyl)anthracene and 9,10-bis[4-(2,2-diphenyl-ethenyl)phenyl]anthracene, 9,10-diphenylanthracene, 9,10-bis(phenyl-ethynyl)anthracene and 1,4-bis(9'-ethynylanthracenyl)benzene. Preference is also given to host materials containing two anthracene units (US 2008/0193796 A1), for example 10,10'-bis[1,1',4',1"]terphenyl-2-yl-9,9'-bisanthracenyl.

Further preferred host materials are derivatives of arylamine, styrylamine, fluorescein, perynone, phthaloperynone, naphthaloperynone, diphenyl-butadiene, tetraphenylbutadiene, cyclopentadienes, tetraphenylcyclopentadiene, pentaphenylcyclopentadiene, coumarine, oxadiazole, bisbenzoxazoline, oxazone, pyridine, pyrazine, imine, benzothiazole, benzoxazole, benzimidazole (US 2007/0092753 A1), for example 2,2',2"-(1,3,5-phenylene)tris[1-phenyl-1H-benzimidazole], aldazines, stilbene, styrylarylene derivatives, for example 9,10-bis[4-(2,2-diphenylethenyl)-phenyl]anthracene, and distyrylarylene derivatives (US 5121029), diphenylethylene, vinylanthracene, diaminocarbazole, pyran, thiopyran, diketopyrrolopyrrole, polymethine, mellocyanine, acridone, quinacridone, cinnamic acid esters and fluorescent dyes.

Particular preference is given to derivatives of arylamine and styrylamine, for example 4,4'-bis[N-(1-naphthyl)-N-(2-naphthyl)amino]biphenyl (TNB).

Preferred compounds with oligoarylene as hosts for fluorescent emitter are compounds as disclosed in, e.g., US 2003/0027016 A1, US 7326371 B2, US 2006/043858 A, US 7326371 B2, US 2003/0027016 A1, WO 2007/114358, WO 2008/145239, JP 3148176 B2, EP 1009044, US 2004/018383, WO 2005/061656 A1, EP 0681019B1, WO 2004/013073A1, US 5077142, WO 2007/065678, and US 2007/0205412 A1. Particularly preferred oligoarylene-based compounds are compounds having the Formulae 40 to 46.

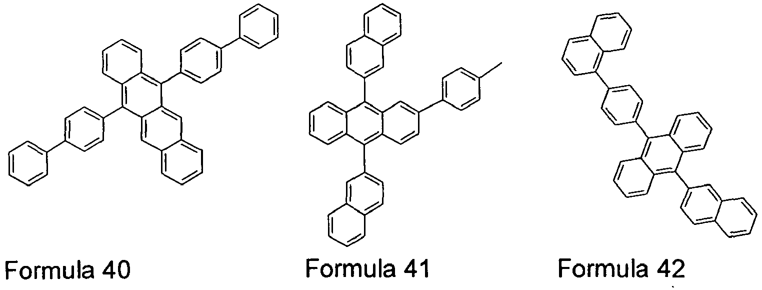

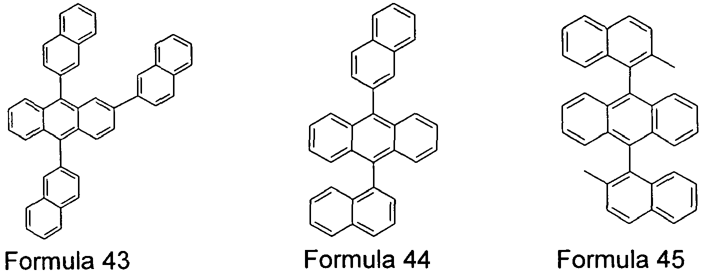

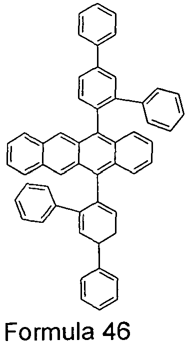

Further host materials for fluorescent emitter can be selected from spirobifluorene and derivates thereof, for example Spiro-DPVBi as disclosed in EP 0676461 and indenofluorene as disclosed in US 6562485.

The preferred host materials for phosphorescent emitter, i.e. matrix materials, are selected from ketones, carbazoles, triarylamines, indenofluorenes, fluorenes, spirobifluorenes, phenathrenes, dehydrophenanthrenes, thiophenes, triazines, imidazoles and their derivatives. Some preferred derivatives are described below in more details.

If a phosphorescent emitter is employed, e.g. as electroluminescent component in organic light emitting diodes (OLEDs), the host material must fulfil rather different characteristics as compared to host materials used for fluorescent emitter. The host materials used for phosphorescent emitter are required to have a triplet level which is higher in energy as compared to the triplet level of the emitter. The host material can either transport electrons or holes or both of them. In addition, the emitter is supposed to have large spin-orbital coupling constants in order to facilitate singlet-triplet mixing sufficiently. This can be enabled by using metal complexes.

Preferred matrix materials are N,N-biscarbazolylbiphenyl (CBP), carbazole derivatives (for example in accordance with WO 2005/039246, US 2005/0069729, JP 2004/288381, EP 1205527 or DE 102007002714), azacarbazoles (for example in accordance with EP 1617710, EP 1617711, EP 1731584, JP 2005/347160), ketones (for example in accordance with WO 2004/093207), phosphine oxides, sulfoxides and sulfones (for example in accordance with WO 2005/003253), oligophenylenes, aromatic amines (for example in accordance with US 2005/0069729), bipolar matrix materials (for example in accordance with WO 2007/137725), silanes (for example in accordance with WO 2005/111172), 9,9-diarylfluorene derivatives (e.g. in accordance with DE 102008017591), azaboroles or boronic esters (for example in accordance with WO 2006/117052), triazole derivatives, oxazoles and oxazole derivatives, imidazole derivatives, polyarylalkane derivatives, pyrazoline derivatives, pyrazolone derivatives, distyrylpyrazine derivatives, thiopyran dioxide derivatives, phenylenediamine derivatives, tertiary aromatic amines, styrylamines, indoles, anthrone derivatives, fluorenone derivatives, fluorenylidenemethane derivatives, hydrazone derivatives, silazane derivatives, aromatic dimethylidene compounds, porphyrin compounds, carbodiimide derivatives, diphenylquinone derivatives, phthalocyanine derivatives, metal complexes of 8 hydroxyquinoline derivatives, such as, for example, Alq₃, the 8 hydroxyquinoline complexes may also contain triarylaminophenol ligands (US 2007/0134514 A1), various metal complex-polysilane compounds with metal phthalocyanine, benzoxazole or benzothiazole as ligand, hole-conducting polymers, such as, for example, poly(N-vinylcarbazole) (PVK), aniline copolymers, thiophene oligomers, polythiophenes, polythiophene derivatives, polyphenylene derivatives, polyfluorene derivatives.

Further particularly preferred matrix materials are selected from compounds comprising indolocarbazoles and their derivatives (e.g. Formulae 47 to 53), as disclosed for examples in DE 102009023155.2, EP 0906947B1, EP 0908787B1, EP 906948B1, WO 2008/056746A1, WO 2007/063754A1, WO 2008/146839A1, and WO 2008/149691A1.

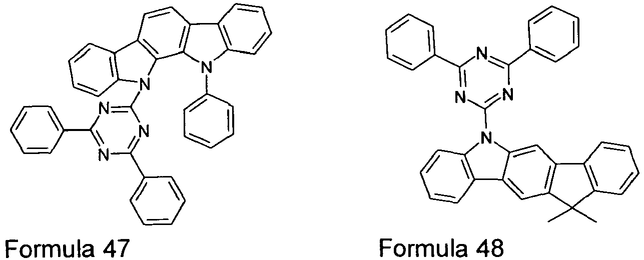

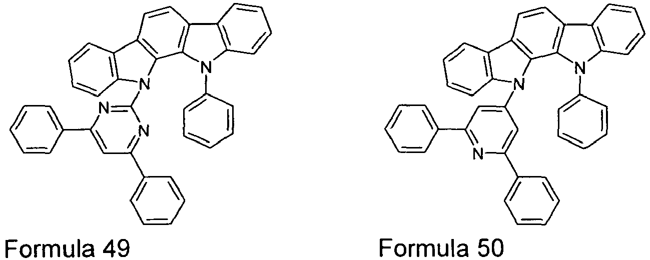

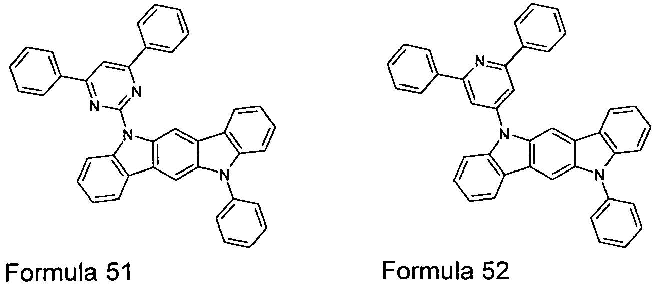

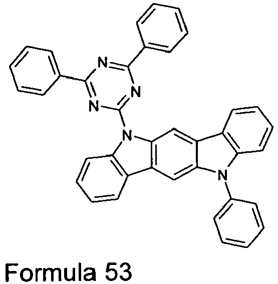

Examples of preferred carbazole derivatives are, 1,3-N,N-dicarbazol-ebenzene (= 9,9'-(1,3-phenylene)bis-9H-carbazole) (mCP), 9,9'-(2,2'-dimethyl[1,1'-biphenyl]-4,4'-diyl)bis-9H-carbazole (CDBP), 1,3-bis(N,N'-dicarbazole)benzene (= 1,3-bis(carbazol-9-yl)benzene), PVK (polyvinyl-carbazole), 3,5-di(9H-carbazol-9-yl)biphenyl and compounds of the Formulae 40 to 44.

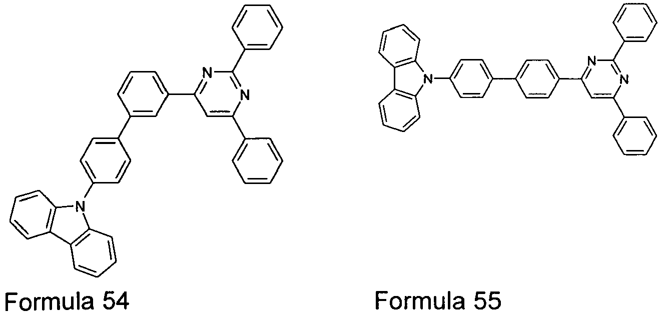

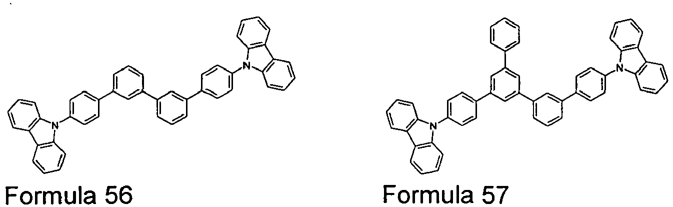

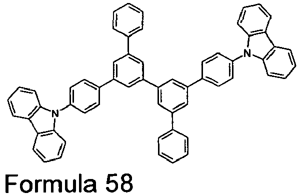

Preferred Si tetraaryl compounds are, for example, (US 2004/0209115, US 2004/0209116, US 2007/0087219 A1, US 2007/0087219 A1) the compounds of the Formulae 59 to 64.

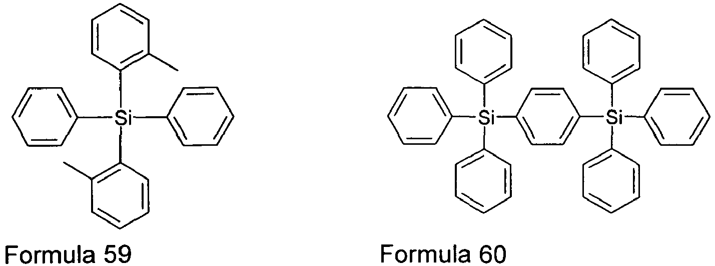

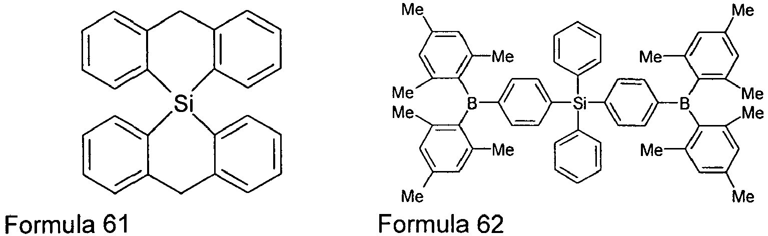

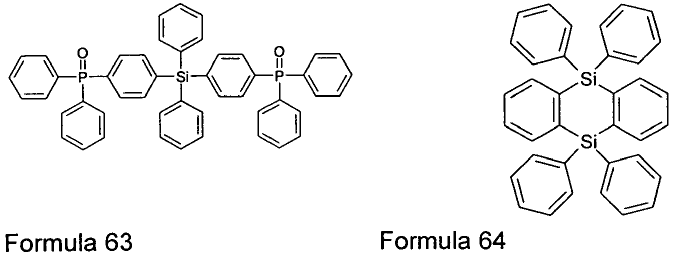

A particularly preferred matrix for phosphorescent dopants is the compound of Formula 65 (EP 652273 B1)

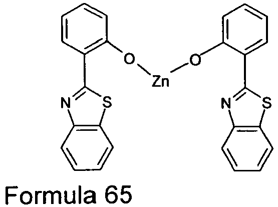

Further particularly preferred matrix materials for phosphorescent dopants are selected from compounds of the general Formula 66 (EP 1923448A1).

[M(L)₂]ₙ Formula 66

wherein M, L, and n are defined as in the reference. Preferably M is Zn, and L is quinolinate, and n is 2, 3 or 4. Very particularly preferred are [Znq₂]₂, [Znq₂]₃, and [Znq₂]₄.

Preference is given to co-hosts selected from metal oxinoid complexes whereby lithium quinolate (Liq) or Alq₃ are particularly preferred.

The emitter compound is required to have a smaller band gap as compared to the host compound. In general, smaller band gaps can be achieved by extending the π-electron system of conjugated molecular systems. Emitter compounds tend, therefore, to have more extended conjugated π-electron systems than host molecules. Many examples have been published, e.g. styrylamine derivatives as disclosed in JP 2913116B and WO 2001/021729 A1, and indenofluorene derivatives as disclosed in WO 2008/006449 and WO 2007/140847.

Blue fluorescent emitters are preferably polyaromatic compounds, such as, for example, 9,10-di(2-naphthylanthracene) and other anthracene derivatives, derivatives of tetracene, xanthene, perylene, such as, for example, 2,5,8,11-tetra-t-butylperylene, phenylene, for example 4,4'-(bis(9-ethyl-3-carbazovinylene)-1,1'-biphenyl, fluorene, arylpyrenes (US 2006/0222886), arylenevinylenes (US 5121029, US 5130603), derivatives of rubrene, coumarine, rhodamine, quinacridone, such as, for example, N,N'-dimethylquinacridone (DMQA), dicyanomethylenepyrane, such as, for example, 4 (dicyanoethylene)-6-(4-dimethylaminostyryl-2-methyl)-4H-pyrane (DCM), thiopyrans, polymethine, pyrylium and thiapyrylium salts, periflanthene, indenoperylene, bis(azinyl)imine-boron compounds (US 2007/0092753 A1), bis(azinyl)methene compounds and carbostyryl compounds.

Further preferred blue fluorescent emitters are described in C.H. Chen et al.: "Recent developments in organic electroluminescent materials" Macromol. Symp. 125, (1997), 1-48 and "Recent progress of molecular organic electroluminescent materials and devices" Mat. Sci. and Eng. R, 39 (2002), 143-222.

Preferred fluorescent dopants according to the present invention are selected from the class of the monostyrylamines, the distyrylamines, the tristyrylamines, the tetrastyrylamines, the styrylphosphines, the styryl ethers and the arylamines.

A monostyrylamine is taken to mean a compound which contains one substituted or unsubstituted styryl group and at least one, preferably aromatic, amine. A distyrylamine is taken to mean a compound which contains two substituted or unsubstituted styryl groups and at least one, preferably aromatic, amine. A tristyrylamine is taken to mean a compound which contains three substituted or unsubstituted styryl groups and at least one, preferably aromatic, amine. A tetrastyrylamine is taken to mean a compound which contains four substituted or unsubstituted styryl groups and at least one, preferably aromatic, amine. The styryl groups are particularly preferably stilbenes, which may also be further substituted. The corresponding phosphines and ethers are defined analogously to the amines. For the purposes of this invention, an arylamine or an aromatic amine is taken to mean a compound which contains three substituted or unsubstituted aromatic or heteroaromatic ring systems bonded directly to the nitrogen. At least one of these aromatic or heteroaromatic ring systems is preferably a condensed ring system, preferably having at least 14 aromatic ring atoms. Preferred examples thereof are aromatic anthracene-amines, aromatic anthracene-diamines, aromatic pyrene-amines, aromatic pyrene-diamines, aromatic chrysene-amines and aromatic chrysene-diamines. An aromatic anthracene-amine is taken to mean a compound in which one diarylamino group is bonded directly to an anthracene group, preferably in the 9 position. An aromatic anthracene-diamine is taken to mean a compound in which two diarylamino groups are bonded directly to an anthracene group, preferably in the 9,10-position. Aromatic pyrene-amines, pyrene-diamines, chrysene-amines and chrysene-diamines are defined analogously thereto, where the diarylamino groups on the pyrene are preferably bonded in the 1 position or in the 1,6-position.

Further preferred fluorescent dopants are selected from indenofluorene-amines and indenofluorene-diamines, for example in accordance with WO 2006/122630, benzoindenofluorene-amines and benzoindenofluorene-diamines, for example in accordance with WO 2008/006449, and dibenzoindenofluorene-amines and dibenzoindenofluorene-diamines, for example in accordance with WO 2007/140847.

Examples of dopants from the class of the styrylamines are substituted or unsubstituted tristilbene-amines or the dopants described in WO 2006/000388, WO 2006/058737, WO 2006/000389, WO 2007/065549 and WO 2007/115610. Distyrylbenzene and distyrylbiphenyl derivatives are described in US 5121029. Further styrylamines are found in US 2007/0122656 A1.

Particularly preferred styrylamine dopants and triarylamine dopants are the compounds of the Formulae 67 to 72 and as disclosed in US 7250532 B2, DE 102005058557 A1, CN 1583691 A, JP 08053397 A, US 6251531 B1, and US 2006/210830 A.

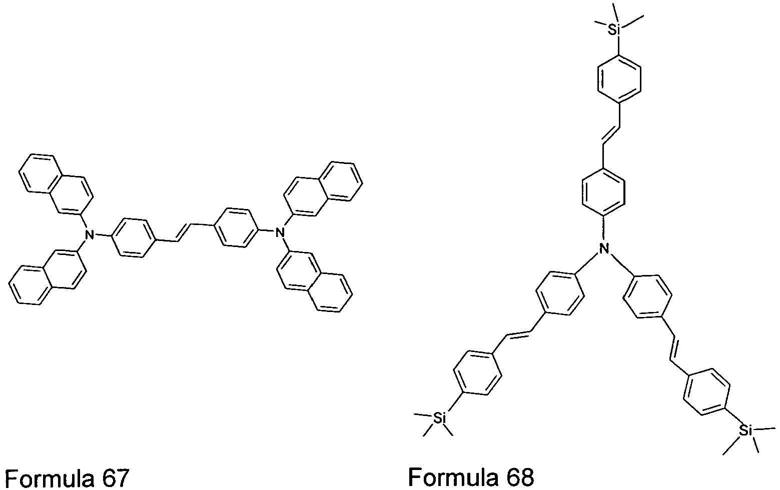

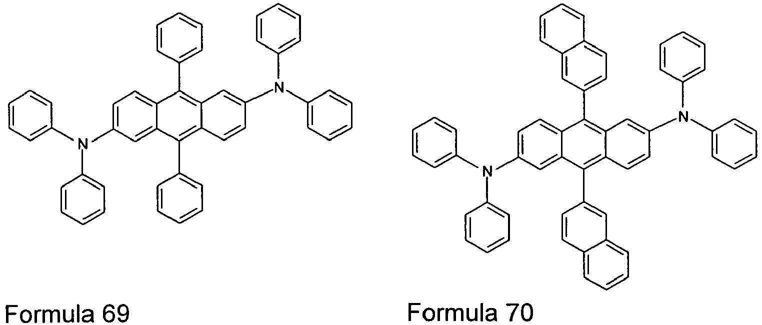

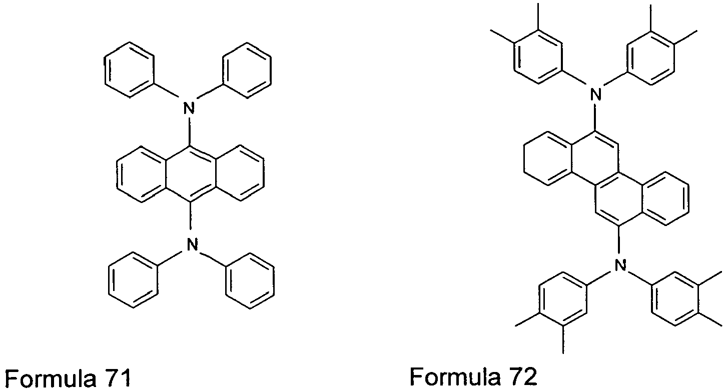

Further preferred fluorescent dopants are selected from the group of triarylamines as disclosed in EP 1957606 A1 and US 2008/0113101 A1.

Further preferred fluorescent dopants are selected from derivatives of naphthalene, anthracene, tetracene, fluorene, periflanthene, indenoperylene, phenanthrene, perylene (US 2007/0252517 A1), pyrene, chrysene, decacyclene, coronene, tetraphenylcyclopentadiene, pentaphenylcyclopentadiene, fluorene, spirofluorene, rubrene, coumarine (US 4769292, US 6020078, US 2007/0252517 A1), pyran, oxazone, benzoxazole, benzothiazole, benzimidazole, pyrazine, cinnamic acid esters, diketopyrrolopyrrole, acridone and quinacridone (US 2007/0252517 A1).

Of the anthracene compounds, particular preference is given to 9,10-substituted anthracenes, such as, for example, 9,10-diphenylanthracene and 9,10-bis(phenylethynyl)anthracene. 1,4-Bis(9'-ethynylanthracenyl)benzene is also a preferred dopant.

Examples of phosphorescent emitters are revealed by the applications WO 00/70655, WO 01/41512, WO 02/02714, WO 02/15645, EP 1191613, EP 1191612, EP 1191614 and WO 2005/033244. In general, all phosphorescent complexes as used in accordance with the prior art for phosphorescent OLEDs and as are known to the person skilled in the art in the area of organic electroluminescence are suitable, and the person skilled in the art will be able to use further phosphorescent complexes without inventive step.

The phosphorescent emitter may be a metal complex, preferably with the formula M(L)_{z}, wherein M is a metal atom, L is in each occurrence independently of one another an organic ligand that is bonded to or coordinated with M via one, two or more positions, and z is an integer ≥ 1, preferably 1, 2, 3, 4, 5 or 6, and wherein, optionally, these groups are linked to a polymer via one or more, preferably one, two or three positions, preferably via the ligands L.

M is in particular a metal atom selected from transition metals, preferably selected from transition metals of group VIII, or lanthanoides, or actinides, particularly preferably selected from Rh, Os, Ir, Pt, Pd, Au, Sm, Eu, Gd, Tb, Dy, Re, Cu, Zn, W, Mo, Pd, Ag, or Ru, and very particularly preferably selected from Os, Ir, Ru, Rh, Re, Pd, or Pt. M may also be Zn.

Preferred ligands are 2 phenylpyridine derivatives, 7,8-benzoquinoline derivatives, 2 (2-thienyl)pyridine derivatives, 2(1-naphthyl)pyridine derivatives or 2 phenylquinoline derivatives. All these compounds may be substituted, for example by fluoro- or trifluoromethyl substituents for blue. Auxiliary ligands are preferably acetylacetonate or picric acid.

In particular, complexes of Pt or Pd with tetradentate ligands of the Formula 73 as disclosed in US 2007/0087219 A1, wherein R¹ to R¹⁴ and Z¹ to Z⁵ are as defined in the reference, Pt porphyrin complexes having an enlarged ring system (US 2009/0061681 A1) and Ir complexes are suitable, for example 2,3,7,8,12,13,17,18-octaethyl-21H, 23H-porphyrin-Pt(II), tetraphenyl-Pt(II)-tetrabenzoporphyrin (US 2009/0061681 A1), cis-bis(2-phenylpyridinato-N,C2')Pt(II), cis-bis(2-(2'-thienyl)pyridinato-N,C3')Pt(II), cis-bis(2-(2'-thienyl)quinolinato-N,C5')Pt(II), (2-(4,6-difluorophenyl)pyridinato-N,C2')Pt(II) acetylacetonate, or tris(2-phenylpyridinato-N,C2')Ir(III) (Ir(ppy)₃, green), bis(2-phenylpyridinato-N,C2)Ir(III) acetylacetonate (Ir(ppy)₂ acetylacetonate, green, US 2001/0053462 A1, Baldo, Thompson et al. Nature 403, (2000), 750-753), bis(1-phenylisoquinolinato-N,C2')(2-phenylpyridinato-N,C2')iridium(III), bis(2-phenylpyridinato-N,C2')(1-phenylisoquinolinato-N,C2')iridium(III), bis(2-(2'-benzothienyl)pyridinato-N,C3')iridium(III) acetylacetonate, bis(2-(4',6'-difluorophenyl)pyridinato-N,C2')iridium(III) piccolinate (Firpic, blue), bis(2-(4',6'-difluorophenyl)pyridinato-N,C2')Ir(III)tetrakis(1-pyrazolyl)borate, tris(2-(biphenyl-3-yl)-4-tert-butylpyridine)iridium(III), (ppz)₂Ir(5phdpym) (US 2009/0061681 A1), (45ooppz)₂Ir(5phdpym) (US 2009/0061681 A1), derivatives of 2 phenylpyridine-Ir complexes, such as, for example, iridium(III) bis(2-phenylquinolyl-N,C2')acetylacetonate (PQIr), tris(2-phenylisoquinolinato-N,C)Ir(III) (red), bis(2-(2'-benzo[4,5-a]thienyl)-pyridinato-N,C3)lr acetylacetonate ([Btp2Ir(acac)], red, Adachi et al. Appl. Phys. Lett. 78 (2001), 1622-1624).

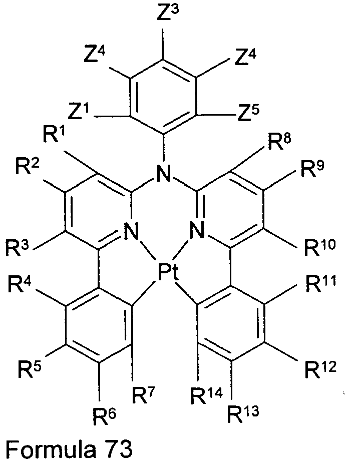

Also suitable are complexes of trivalent lanthanides, such as, for example, Tb³⁺ and Eu³⁺ (J. Kido et al. Appl. Phys. Lett. 65 (1994), 2124, Kido et al. Chem. Lett. 657, 1990, US 2007/0252517 A1), or phosphorescent complexes of Pt(II), Ir(I), Rh(I) with maleonitrile dithiolate (Johnson et al., JACS 105, 1983, 1795), Re(I) tricarbonyl diimine complexes (Wrighton, JACS 96, 1974, 998 inter alia), Os(II) complexes with cyano ligands and bipyridyl or phenanthroline ligands (Ma et al., Synth. Metals 94, 1998, 245) or Alq₃ without a host.

Further phosphorescent emitters with tridentate ligands are described in US 6824895 and US 7029766. Red-emitting phosphorescent complexes are mentioned in US 6835469 and US 6830828.

A particularly preferred phosphorescent dopant is a compound with the Formula 74 and further compounds as disclosed, e.g., in US 2001/0053462 A1.

A particularly preferred phosphorescent dopant is a compound with the Formula 75 and further compounds as disclosed, e.g., in WO 2007/095118 A1

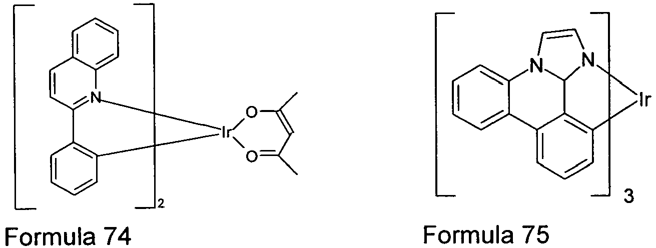

Further derivatives are described in US 7378162 B2, US 6835469 B2, and JP 2003/253145 A.

Further to metal complex mentioned elsewhere herein, a suitable metal complex according to the present invention can be selected from transition metals, rare earth elements, lanthanides and actinides is also subject of this invention. Preferably the metal is selected from Ir, Ru, Os, Eu, Au, Pt, Cu, Zn, Mo, W, Rh, Pd, or Ag.

Further to dyes mentioned elsewhere herein, dyes according to the invention can be selected from perylenes, ruthenium dyes, phthalocyanines, azo dyes, perylene-diimides, porphyrines, squaraines, isomers and derivatives thereof.

Preferably the dye is selected from perylenes, ruthenium dyes, phthalocyanines, azo dyes, perylene-diimides, porphyrines, and squaraines. Also preferred are dyes selected from ruthenium complexes as disclosed by Yu Bai et. al., in Nature Materials, Vol7, 626 (2008) and by B. O'Regan et. al., in Nature 353, 737 (1991), and Cu based complexes as disclosed by Bessho et al, in Chem. Commun. 3717 (2008).

Further dyes are selected from acridines, anthraquinones, arylmethanes, diarylmethanes, triarylmethanes, azo-based dyes, cyanines, diazonium-based dyes, nitro-based dyes, nitroso-based dyes, quinone-imines, azin-based dyes, eurhodines, safranines, indulines, indamins, indophenoles, oxazines, oxazones, thiazines, thiazoles, xanthenes, fluorenes, pyronines, fluorones, and rhodamines.
In addition to dyes according to the present invention, charge generation materials can also have the same function as a dye. They are, for example, used for electrophotographic devices. Thus charge generation materials as summarized by Paul M.Borsenberger; and David S.Weiss in Organic Photorecptors for Xerography; Marcel Dekker, Inc., 1998, Chapter 6, and by K. Y. Law, Chem. Rev. Vol93, 449-486 (1993) are herein also considered as suitable dye.

Further suitable dyes are selected from organic compounds containing fused ring system, for example anthracene, naphthalene, pentacene and tetracence derivatives.

Formulations according to the present invention can comprise functional materials selected from small molecules, polymers, oligomers, dendrimers, and blends. The functional polymer is characterized in that different functions may be incorporated into one large molecule or a blend of large molecules. The functions are, inter alia, the ones of a hole injection material, hole transport material, electron blocking material, emissive material, hole blocking material, electron injection material, electron transport material, and dye. The functions which are incorporated into a polymer can be categorized into different groups. By choosing the desired functional groups and the ratio between them, the polymer can be tuned to have the desired function(s).

The difference between polymers, oligomers and dendrimers is due to the size, size distribution, and branching of the molecular entities as defined above.

Different structures are, inter alia, those as disclosed and extensively listed in WO 2002/077060 A1 and in DE 10337346 A1. The structural units may originate, for example, from the following groups:
- Group 1:: units which increase the hole-injection and/or transport properties of the polymers; It corresponds to the HIMs or HTMs as described above.
- Group 2:: units which increase the electron-injection and/or transport properties of the polymers; It corresponds to the ElMs or ETMs as described above.
- Group 3:: units which have combinations of individual units from group 1 and group 2;
- Group 4:: units which modify the emission characteristics to such an extent that electrophosphorescence may be obtained instead of electrofluorescence; typically, it corresponds to the phosphorescent emitter, or more preferably emissive metal complexes as described above.
- Group 5:: units which improve the transition from the so called singlet state to higher spin states, e.g. to a triplet state;
- Group 6:: units which influence the morphology and/or emission colour of the resultant polymers;
- Group 7:: units which are typically used as backbone and which may have electron transport function, hole transport function or both.
- Group 8:: units which have strong absorption in at least one wavelength from UV to infrared. It corresponds to the dye materials as described above.

Preferably, the said functional material is a hole transport or injection polymer comprising units of groups 1, which are preferably selected from units comprising the low molecular weight HTMs or HIMs as described above.

Further preferred units from group 1 are, for example, triarylamine, benzidine, tetraaryl-para-phenylenediamine, carbazole, azulene, thio¬phene, pyrrole and furan derivatives and further O, S or N containing heterocycles with a high HOMO. These arylamines and heterocycles preferably result in an HOMO in the polymer of greater than 5.8 eV (against vacuum level), particularly preferably greater than 5.5 eV.

Preferred polymeric HTM or HIM is a polymer comprising at least one of following repeat unit according to Formulae 76. 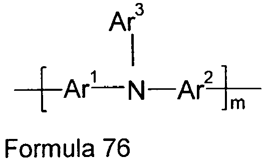 wherein
Ar¹ which may be the same or different, denote, independently if in different repeat units, a single bond or an optionally substituted mononuclear or polynuclear aryl group,
Ar² which may be the same or different, denote, independently if in different repeat units, an optionally substituted mononuclear or polynuclear aryl group,
Ar³ which may be the same or different, denote, independently if in different repeat units, an optionally substituted mononuclear or polynuclear aryl group,
m is 1, 2 or 3.

Particularly preferred units of Formula 76 are selected from the group consisting of the Formulae 77 to 79: 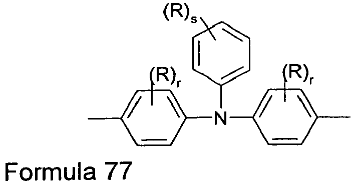 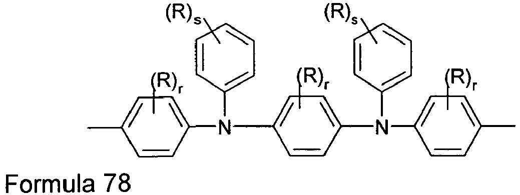 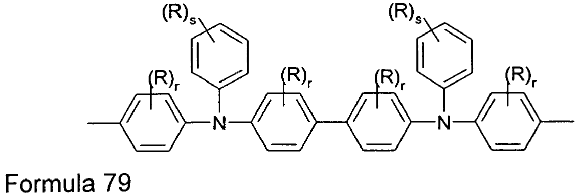 wherein
R which may be the same or different in each occurrence, is selected from H, substituted or unsubstituted aromatic or heteroaromatic group, alkyl, cycloalkyl,alkoxy, aralkyl, aryloxy, arylthio, alkoxycarbonyl, silyl, carboxy group, a halogen atom, cyano group, nitro group or hydroxy group,
r is 0, 1, 2, 3 or 4, and
s is 0, 1, 2, 3, 4 or 5.

Further preferred polymeric HTM or HIM is a polymer comprising at least one of following repeat unit according to Formulae 80.

-(T¹)_{c}-(Ar⁴)_{d}-(T²)ₑ-(Ar⁵)_{f}- Formula 80

wherein
T¹ and T² are independently of each other selected from thiophene, selenophene, thieno[2,3b]thiophene, thieno[3,2b]thiophene, dithienothiophene, pyrrole, aniline , all of which are optionally substituted with R⁵,
R⁵ is in each occurrence independently of each other selected from halogen, -CN, -NC, -NCO, -NCS, -OCN, SCN, C(=O)NR⁰R⁰⁰, -C(=O)X, - C(=O)R⁰, -NH₂, -NR⁰R⁰⁰, SH, SR⁰, -SO₃H, -SO₂R⁰, -OH, -NO₂, -CF₃, -SF₅, optionally substituted silyl, or carbyl or hydrocarbyl with 1 to 40 C atoms that is optionally substituted and optionally contains one or more hetero atoms,
Ar⁴ and Ar⁵ are independently of each other mononuclear or polynuclear aryl or heteroaryl, which is optionally substituted and optionally fused to the 2,3-positions of one or both of the adjacent thiophene or selenophene groups,
c and e are independently of each other 0, 1, 2, 3 or 4, with 1 < c + e ≤ 6,
d and f are independently of each other 0, 1, 2, 3 or 4.

Examples for polymeric HTMs are as disclosed in WO 2007131582 A1 and WO 2008/009343A1.

Preferably, the said functional material is an electron transport or injection polymer comprising groups 2, which is preferably selected from groups comprising the low molecular weight ETMs or ElMs as described above. Further preferred units from group 2, which have electron-injection or electron-transport properties, are, for example, pyridine, pyrimidine, pyridazine, pyrazine, oxadiazole, quinoline, quinoxaline and phenazine derivatives, but also triarylboranes and further O, S or N containing heterocycles having a low LUMO. These units in the polymer preferably result in an LUMO of less than 2.7 eV (against vacuum level), particularly preferably less than 2.8 eV.

Preferably, the said functional material is a polymer comprising units from group 3 in which structures which increase the hole mobility and the electron mobility (i.e. units from groups 1 and 2) are bonded directly to one another. Some of these units may serve as emitters and shift the emission colour into the green, yellow or red. Their use is thus suitable, for example, for the production of other emission colours or a broad-band emission from originally blue-emitting polymers.

Preferably, the said functional material is a polymer comprising units of group 4, which is preferably selected from the groups comprising phosphorescent emitter, particularly emissive metal complexes as described above. Particular preference is given here to corresponding structural units which contain elements from groups 8 to 10 (Ru, Os, Rh, Ir, Pd, Pt).

Preferably, the said functional material is a polymeric triple matrix comprising units of group 5, which can improve the transition from the singlet state to the triplet state and which, employed in support of the structural elements from group 4, improve the phosphorescence properties of these structural elements. Suitable for this purpose are, in particular, carbazole and bridged carbazole dimer units, as described in DE 10304819 A1 and DE 10328627 A1. Also suitable for this purpose are ketones, phosphine oxides, sulfoxides, sulfones, silane derivatives and similar compounds, as described in DE 10349033 A1. Further preferred structure units can be selected from groups comprising the low molecular weight phosphorescent matrices as described above.

Preferably, the said functional material is a polymer comprising units of group 6, which influence the morphology and/or emission colour of the polymers, are, besides those mentioned above, those which have at least one further aromatic or another conjugated structure which do not fall under the above-mentioned groups, i.e. which have only little effect on the charge-carrier mobilities, which are not organometallic complexes or which have no influence on the singlet-triplet transition. Structural elements of this type may influence the morphology and/or emission colour of the resultant polymers. Depending on the unit, they can therefore also be employed as emitters. Preference is given here, in the case of fluorescent OLEDs, to aromatic structures having 6 to 40 C atoms or also tolan, stilbene or bisstyrylarylene derivatives, each of which may be substituted by one or more radicals R1. Particular preference is given here to the incorporation of 1,4-phenylene, 1,4-naphthylene, 1,4- or 9,10-anthrylene, 1,6-, 2,7- or 4,9-pyrenylene, 3,9- or 3,10-perylenylene, 4,4'-biphenylylene, 4,4"-terphenylylene, 4,4' bi 1,1'-naphthylylene, 4,4'-tolanylene, 4,4'-stilbenylene or 4,4"-bisstyrylarylene derivatives.

Preferably, the said functional material is a polymer comprising units of group 7 which contain aromatic structures having 6 to 40 C atoms which are typically used as polymer backbone. These are, for example, 4,5-dihydropyrene derivatives, 4,5,9,10-tetrahydropyrene derivatives, fluorene derivatives as disclosed for example in US 5962631, WO 2006/052457 A2 and WO 2006/118345A1, 9,9'-spirobifluorene derivatives as disclosed for example in WO 2003/020790 A1, 9,10-phenanthrene derivatives as disclosed, for example, in WO 2005/104264 A1, 9,10-dihydrophenanthrene derivatives as disclosed for example in WO 2005/014689 A2, 5,7-dihydrodibenzooxepine derivatives and cis- and trans-indenofluorene derivatives as disclosed for example in WO 2004041901 A1, WO 2004113412 A2 and, binaphthylene derivatives as disclosed for example in WO 2006/063852 A1, and further units as disclosed for example in WO 2005/056633A1, EP 1344788A1 and WO 2007/043495A1, WO 2005/033174 A1, WO 2003/099901A1 and DE 102006003710.3.

Further preferred structural elements from group 7 are selected from fluorene derivatives, as disclosed for example in US 5,962,631, WO 2006/052457 A2 and WO 2006/118345 A1, spiro-bifluorene derivatives as disclosed for example in WO 2003/020790 A1, benzofluorene, dibenzofluorene, benzothiophene, dibenzofluorene and their derivatives as disclosed for example in WO 2005/056633A1, EP 1344788A1 and WO 2007/043495A1

Very preferred structural elements of group 7 are those of Formula 81: 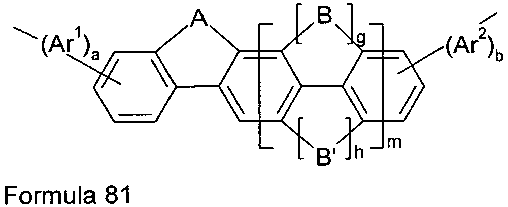 wherein
A, B and B' are independently of each other, and in case of multiple occurrence independently of one another, a divalent group, preferably selected from -CR¹R²-, -NR¹-, -PR¹-, -O-, -S-, -SO-, -SO₂-, -CO-, -CS-, - CSe-, -P(=O)R¹-, -P(=S)R¹- and -SiR¹R²-,
R¹ and R² are independently of each other identical or different groups selected from H, halogen, -CN, -NC, -NCO, -NCS, -OCN, -SCN, - C(=O)NR⁰R⁰⁰, -C(=O)X, -C(=O)R⁰, -NH₂, -NR⁰R⁰⁰, -SH, -SR⁰, -SO₃H, - SO₂R⁰, -OH, -NO₂, -CF₃, -SF₅, optionally substituted silyl, or carbyl or hydrocarbyl with 1 to 40 C atoms that is optionally substituted and optionally comprises one or more hetero atoms, and optionally the groups R¹ and R² form a spiro group with the fluorene moiety to which they are attached,
X is halogen,
R⁰ and R⁰⁰ are independently of each other H or an optionally substituted carbyl or hydrocarbyl group optionally comprising one or more hetero atoms,
each g is independently 0 or 1 and each corresponding h in the same subunit is the other of 0 or 1,
m is an integer ≥ 1
Ar¹ and Ar² are independently of each other mono- or polynuclear aryl or heteroraryl that is optionally substituted and optionally fused to the 7,8-positions or 8,9-positions of the indenofluorene group,
a and b are independently of each other 0 or 1.

If the groups R¹ and R² form a spiro group with the fluorene group to which they are attached, it is preferably spirobifluorene.

The groups of Formula 81 are preferably selected from the following Formulae 82 to 86: 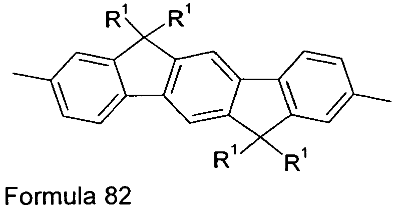 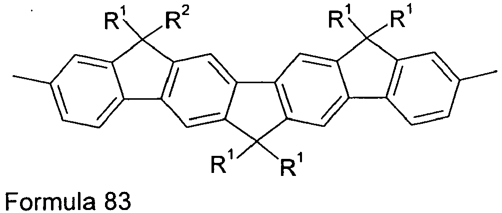 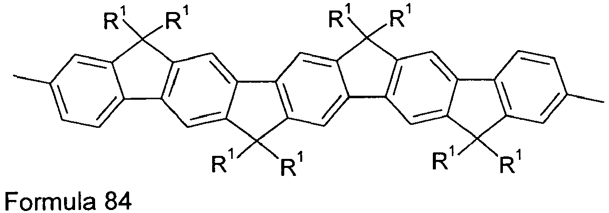 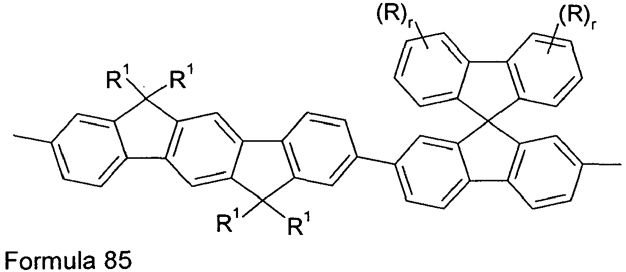 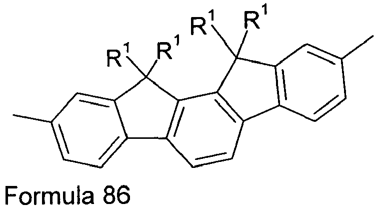 wherein R¹ is as defined in Formula 81, r is 0, 1, 2, 3 or 4, and R has one of the meanings of R¹.

R is preferably F, Cl, Br, I, -CN, -NO₂ , -NCO, -NCS, -OCN, -SCN, - C(=O)NR⁰R⁰⁰, -C(=O)X⁰, -C(=O)R⁰, -NR⁰R⁰⁰, optionally substituted silyl, aryl or heteroaryl with 4 to 40, preferably 6 to 20 C atoms, or straight chain, branched or cyclic alkyl, alkoxy, alkylcarbonyl, alkoxycarbonyl, alkylcarbonlyoxy or alkoxycarbonyloxy with 1 to 20, preferably 1 to 12 C atoms, wherein one or more H atoms are optionally replaced by F or Cl, and wherein R⁰, R⁰⁰ and X⁰ are as defined above.

Particularly preferred groups of Formula 81 are selected from the following Formulae 87 to 90: 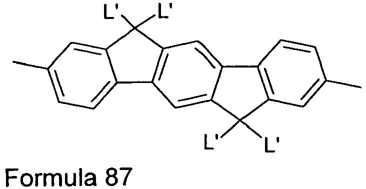 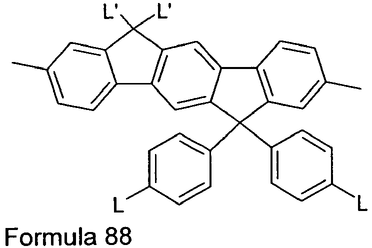 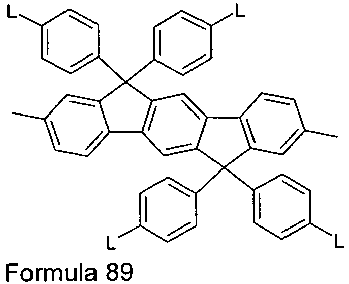 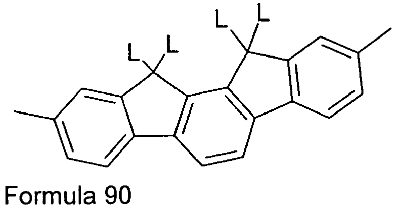 wherein
L is H, halogen or optionally fluorinated, linear or branched alkyl or alkoxy with 1 to 12 C atoms, and is preferably H, F, methyl, i-propyl, t-butyl, n-pentoxy, or trifluoromethyl, and
L' is optionally fluorinated, linear or branched alkyl or alkoxy with 1 to 12 C atoms, and is preferably n-octyl or n-octyloxy.

Preferably, the said functional material is a polymer comprising group 8, which can be selected from the groups comprising the dye materials as described above. The conjugated polymers suitable for organic solar cells, as summarized for example by F.C. Krebs, in Solar Energy Materials and Solar Cells, Vol91, 953 (2007), can also be used as the said organic functional material in the present invention.

Preference is given to polymers suitable for use in the invention which simultaneously comprise one or more units selected from groups 1 to 8. It may likewise be preferred for more than one structural unit from a group to be present simultaneously.

Preference is given to polymers suitable for use in the invention which, besides structural units of an emitter, also comprise at least one structural unit from the above-mentioned groups. At least two structural units are particularly preferably from different classes of those mentioned above.

The proportion of the different classes of groups, if present in the polymer, is preferably in each case at least 5 mol%, particularly preferably in each case at least 10 mol%. In particular, one of these structural units is selected from the group of hole-conducting units and the other group is an emitting unit, where these two functions (hole conduction and emission) may also be taken on by the same unit.

However, a smaller proportion of the emitting units, in particular green- and red-emitting units, may also be preferred, for example for the synthesis of white-emitting copolymers. The way in which white-emitting copolymers can be synthesised is described in detail in DE 10343606 A1.

In order to ensure adequate solubility, it is preferred for on average at least 2 non-aromatic C atoms to be present in the substituents per recurring unit. Preference is given here to at least 4 and particularly preferably at least 8 C atoms. In addition, individual C atoms of these may be replaced by O or S. However, it is entirely possible for this to mean that a certain proportion of recurring units does not carry any further non-aromatic substituents.

In order to avoid impairing the morphology of the film, it is preferred to have no long-chain substituents having more than 12 C atoms in a linear chain, particularly preferably none having more than 8 C atoms and in particular none having more than 6 C atoms.

The polymer used as functional material in the invention may be statistical or random copolymers, alternating or regioregular copolymers, block copolymers or combinations thereof.

In another preferred embodiment, the said polymer is a side-chain non-conjugated polymer, which is especially important for phosphorescent OLEDs based on polymer. In general, such phosphorescent polymer is obtained by means of radical copolymerization of vinyl compounds, and comprises at least one phosphorescent emitter and at least one charge transport unit on side chain, as disclosed in US 7250226 B2. Further examples for such phosphorescent polymer are disclosed for example in JP 2007/211243 A2, JP 2007/197574 A2, US 7250226B2, JP 2007/059939A.

In a further preferred embodiment, the said polymer is a main-chain non-conjugated polymer, where the backbone units are connected by spacer on main-chain. Like side-chain non-conjugated polymer, main-chain non-conjugated polymers give also a high triplet level. An example for triplet OLEDs based on main-chain non-conjugated polymers is disclosed in DE 102009023154.4.

In a further embodiment, the said polymer can also be a non-conjugated polymer for fluorescent OLEDs. Preferred singlet non-conjugated polymers are, for example, side-chain polymers with antracenenes, benzanthrecenes and their derivates in the side-chain, as disclosed in JP 2005/108556, JP 2005/285661, JP 2003/338375 etc..

The said polymers can also act as ETM or HTM, preferably the polymer is a non-conjugated polymer.

Devices according to the present invention may also comprise additional layer which were not deposited by using a formulation, i.e. a emulsion or dispersion according to this invention. The additional layer may be deposited by a technique from solution or by vapour deposition. Hereby the specific method employed depends on the characteristics of the material used and a person skilled in the art has no problem to select the appropriate technique. The material which is deposited can be any material used in the field of electronic and opto-electronic multilayer structures. In particular the material may be any material described herein. Furthermore, the materials may be selected from organic and inorganic functional materials as outlined below.

Inorganic compounds, such as p type Si and p type SiC, and inorganic oxides, e.g., vanadium oxide (VOₓ), molybdenum oxide (MoOₓ) or nickel oxide (NiOₓ) can also be used as HIM.

Electron injection layers (EILs) are often constructed from an insulator and semiconductor.

Preferred alcali metal chalcogenides for EILs are Li₂O, LiO, Na₂S, Na₂Se, NaO, K₂O, Cs₂O.

Preferred alkaline-earth metal chalcogenides for EILs are CaO, BaO, SrO, BeO, BaS, CaSe.

Preferred halides of alkali metals for EILs are LiF, NaF, KF, CsF, LiCl, KCl, NaCl.

Preferred halides of alkaline-earth metals for EILs are CaF₂, BaF₂, SrF₂, MgF₂, BeF₂.

It is likewise possible to employ alkali metal complexes, alkaline-earth metal complexes, rare-earth metals (Sc, Y, Ce, Th, Yb), rare-earth metal complexes, rare-earth metal compounds (preferably YbF₃, ScF₃, TbF₃) or the like.

The structure of ElLs is described, for example, in US 5608287, US 5776622, US 5776623, US 6137223, US 6140763, US 6914269.

An electron-transport layer may consist of an intrinsic material or comprise a dopant. Alq₃ (EP 278757 B1) and Liq (EP 0569827 A2) are examples of intrinsic layers. 4,7-diphenyl-1,10-phenanthroline (Bphen):Li 1:1 (US 2003/02309890) and rubrene/LiF are examples of doped layers.

In addition to the materials mentioned above, an organic electroluminescent device according to the present invention may comprise at least one anode, at least one cathode and one or more substrates.

Preferred materials for the anode are metal oxides selected from, but not limited to, indium tin oxide (ITO), indium zinc oxide (IZO), tin oxide (SnO), ZnO, InO, aluminium-zinc-oxide (AlZnO), and other metal oxides such as Al- and In-zinc oxide doped with zinc oxide, magnesium-indium-oxide, and nickel-tungsten-oxide. Metal nitrides such as galliumnitrides and metal selenides such as zinc-selenide and metal-sulfides such as zinc-sulfide can also be used. Further materials that can be used for anodes are electrically conducting polymers, e.g. polythiophenes and polypyrroles.

The anode can be transparent, opaque, or reflective. The anode can also adopt an intermediate state, e.g. both being partially reflective and partially transparent.

If the anode is not or only partially transparent further conducting materials can be used. Preferred materials for non transparent or partially transparent anodes are selected from, but not limited to, Au, Ir, Mo, Pd, Pt, Cu, Ag, Sn, C, Al, V, Fe, Co, Ni, W, and mixtures thereof. The conducting materials can also be mixed with further conducting materials as described above, e.g. In-Cu.

The anode is preferably transparent and a particularly preferred material for the anode is ITO. In the case of a bottom-emitting device glass or plastic is preferably coated with ITO. In the case of a top-emitting device the anode comprises preferably a reflecting material. Further materials can be used for anodes, which are known to the person skilled in the art.

A flexible and transparent combination of substrate and anode is described in US 5844363 B2 and US 6602540 B2, for instance.

The cathode can be transparent, opaque, or reflective. The cathode is selected from a metal or an alloy with a low work function. Preferably metals, alloys, or conducting compounds or materials with a work function of less than 4.0 eV are used. Particularly preferred cathodes are selected from, but not limited to, Ba, Ca, Sr, Yb, Ga, Cd, Si, Ta, Sb, Zn, Mg, Al, In, Li, Na, Cs, Ag, mixtures of two or more elements such as alloys comprising Mg/Al or Al/Li or Al/Sc/Li or Mg/Ag or metal oxides such as ITO or IZO.

Further preferred materials for cathodes, used to form a thin dielectric layer, are selected from a metal which is mixed with LiF, Li2O, BaF₂, MgO, or NaF. A typical combination is LiF/Al.

An Mg/Al cathode with ITO layer on top is described in US 5703436, US 5707745, US 6548956 B2, US 6576134 B2. An Mg/Ag alloy is described in US 4885221.

The substrate may be rigid or flexible. It may be transparent, translucent, opaque or reflective. The materials used can be glass, plastic, ceramic or metal foils, where plastic and metal foils are preferably used for flexible substrates. However, semiconductor materials, such as, for example, silicone wafers or printed circuit board (PCB) materials, can also be employed in order to simplify the generation of conductor tracks. Other substrates can also be employed.

The glass used can be, for example, soda-lime glass, Ba- or Sr-containing glass, lead glass, aluminium silicate glass, borosilicate glass, Ba borosilicate glass or quartz.

Plastic plates can consist, for example, of polycarbonate resin, acrylic resin, vinyl chloride resin, polyethylene terephthalate resin, polyimide resin, polyester resin, epoxy resin, phenolic resin, silicone resin, fluorine resin, polyether sulfide resin or polysulfone resin.

For transparent films, use is made, for example, of polyethylene, ethylene-vinyl acetate copolymers, ethylene-vinyl alcohol copolymers, polypropylene, polystyrene, polymethyl methacrylate, PVC, polyvinyl alcohol, polyvinylbutyral, nylon, polyether ether ketone, polysulfone, polyether sulfone, tetrafluoroethylene-perfluoroalkyl vinyl ether copolymers, polyvinyl fluoride, tetrafluoroethylene-ethylene copolymers, tetrafluoroethylene-hexafluoropropylene copolymers, polychlorotrifluoroethylene, polyvinylidene fluoride, polyester, polycarbonate, polyurethanes, polyimide or polyether imide.

The substrate is provided with a hydrophobic layer. The substrates are preferably transparent.

Other materials than those mentioned here can also be used. Suitable materials are known to the person skilled in the art.

A preferred formulation according to the present invention is characterized in that the functional surfactant comprises a host group and the discontinuous phase(s) comprise(s) at least one further functional material. Preferably the further functional material is selected from emissive materials and metal complexes, preferably emissive metal complexes. Host groups, emissive materials, and metal complexes can be selected from functional materials described within the present invention.

Preferrred host materials are selected from anthracenes, benzanthracenes, indenofluorenes, fluorenes, spirobifluorenes, phenanthrenes, dehydrophenanthrenes, thiophenes, triazines, imidazole, ketones, carbazoles, triarylamines, and derivatives thereof.

The present invention also relates to said formulation, characterized in that it comprises at least two further functional materials selected from emitter materials wherein the emitter materials are independently from each other selected from fluorescent materials and phosphorescent materials.

The said formulation preferably comprises 4, particularly preferably 3, and very particularly preferably 2 emitter materials. The emitter materials can be in the same phase or in different phases of the formulation, preferably the emitter materials are in the same phase, and particularly preferably the emitter materials are in the same discontinuous phase.

Any known emitter material can be used, but preference is given to emitter materials as described elsewhere within the present invention.

Preference is given to said formulation, characterized in that the functional surfactant comprises one emissive functional group. Preferably this formulation comprises, in addition, a least one further functional material which is preferably selected from emissive materials. Particularly preferably the formulation comprises 2 and very particularly preferably 1 further emissive material. Preferably the discontinuous phase(s) comprise(s) the further emissive materials.
Further preference is given to said formulation characterized in that the continuous phase(s) comprise(s) at least one further functional material selected from host materials, HTMs, and ETMs.

Particular preference is given to a formulation characterized in that it comprises at least one functional surfactant comprising one emissive functional group and in that the discontinuous phase(s) comprise(s) at least one further functional material selected from emissive materials and the continuous phase comprises at least one further functional material selected from host materials.

Particular preference is given to a formulation characterized in that it comprises at least one functional surfactant comprising one emissive functional group and in that the discontinuous phase(s) comprise(s) at least one further functional material selected from emissive materials and the continuous phase comprises at least one further functional material selected from ETMs.

Particular preference is given to a formulation characterized in that it comprises at least one functional surfactant comprising one emissive functional group and in that the discontinuous phase(s) comprise(s) at least one further functional material selected from emissive materials and the continuous phase comprises at least one further functional material selected from host HTMs.

Preferably the said discontinuous phase of the formulation comprises 3, particularly preferably 2, and very particularly preferably 1 further functional material selected from emissive materials.

Preferably the said continuous phase of the formulation comprises 3, particularly preferably 2, and very particularly preferably 1 further functional material selected from host materials.

Preferably the said continuous phase of the formulation comprises 3, particularly preferably 2, and very particularly preferably 1 further functional material selected from ETMs.

Preferably the said continuous phase of the formulation comprises 3, particularly preferably 2, and very particularly preferably 1 further functional material selected from HTMs.

Any known emissive functional group and further functional materials selected from emissive materials, host materials, ETMs, and HTMs can be used, but preference is given to emitter materials as described elsewhere within the present invention.

Preferred ETMs are selected from imidazoles, pyridines, pyrimidines, pyridazines, pyrazines, oxadiazoles, chinolines, chinoxalines, anthracenes, benzanthracenes, pyrenes, perylenes, benzimidazoles, triazines, ketones, phosphinoxides, phenazines, phenanthrolines, triarylboranes and derivatives thereof

Preferred HTMs are selected from amines, triarylamines, thiophenes, carbazoles, phthalocyanines, porphyrines and derivatives thereof.

In a preferred embodiment the said formulation comprises (1) at least one functional surfactant comprising at least one singlet emissive group and (2) a mixture of at least one host material and at least one metal complex.

Preferably the said formulation comprises 3, particularly preferably 2, and very particularly preferably 1 functional surfactant, comprising preferably 3, particularly preferably 2, and very particularly preferably 1 singlet emissive group. The mixture preferably comprises 3, particularly preferably 2, and very particularly preferably 1 host material. Furthermore, the mixture preferably comprises 3, particularly preferably 2, and very particularly preferably 1 metal complex. The groups and materials, e.g., mentioned in the present invention can be used.

Particular preference is given to metal complexes comprising metals selected from transition metals, rare earths, lanthanides and actinides. Very particular preference is given to metal complexes comprising metals selected from Ir, Ru, Os, Eu, Au, Pt, Cu, Zn, Mo, W, Rh, Pd, and Ag.

Preferably the host material and the metal complex are located in the discontinuous phase.

In a further preferred embodiment the formulation according to the present invention comprises (1) at least one functional surfactant comprising at least one dye group and (2) at least one ETM.

Preferably the said formulation comprises 3, particularly preferably 2, and very particularly preferably 1 functional surfactant, comprising preferably 3, particularly preferably 2, and very particularly preferably 1 dye group. The formulation preferably comprises 3, particularly preferably 2, and very particularly preferably 1 ETM.

Preferably the ETM is located in the discontinuous phase of the formulation.

In another embodiment of the present invention the formulation is characterized in that at least one discontinuous phase comprises at least one dye.

Preferably 3, particularly preferably 2 and very particularly preferably 1 of the discontinuous phases comprise preferably 3, particularly preferably 2 and very particularly preferably 1 dyes. Any dyes suitable for the use in opto-electronic devices and known to the skilled person can be selected for this purpose as outlined elsewhere within the present invention.

Preference is given to dyes selected from perylenes, ruthenium dyes, phthalocyanines, azo compounds, perylene diimides, porphyrines, squaraine compounds, and derivatives thereof.

Further preference is given to dyes selected from perylenes, ruthenium dyes, phthalocyanines, azo compounds, perylene diimides, porphyrines, and squaraine compounds.

A further preferred functional material is an electron acceptor, preferably selected from fullerenes, for example C₆₀, carbon nanotubes, graphene isomers and derivatives thereof. Preferably for photovoltaic application, the said dye and said further organic functional material form a type II energy offset structure, with an energy offset larger than 0.4 eV, preferably larger than 0.5 eV and particularly preferably larger than 0.6 eV.

Thus, the formulations comprising at least one fullerene or its derivatives, wherein preferably at least one of the discontinuous phases comprises the said fullerene are also subject of the present invention. Preferably the fullerenes are selected from C₆₀, C₇₀, C₇₆, C₈₀, C₈₆, C₉₀, and C₉₄, isomers and derivatives thereof. C60 fullerene, its isomers and derivatives are particularly preferred.

Further preferred fullerenes suitable for the present invention are selected from carbon allotropes, molecules composed entirely of carbon, in the form of a hollow sphere, ellipsoid, tube, or plane. Spherical fullerenes are also called buckyballs, and cylindrical ones are called carbon nanotubes or buckytubes. Graphene is an example of a planar fullerene sheet.

Preferably 3, particularly preferably 2 and very particularly preferably 1 of the discontinuous phases comprise preferably 3, particularly preferably 2 and very particularly preferably 1 fullerenes.

The present invention further relates to a formulation comprising at least one continuous phase and at least one discontinuous phase, characterized in that the formulation comprises at least one quantum dot.

Preferably the formulation comprises one continuous and one discontinuous phase and at least one quantum dot, preferably 1 to 100, particularly preferably 1 to 50 and very particularly preferably 1 to 10 quantum dots.

Particularly preferably the formulation comprises one continuous and one discontinuous phase and 1 to 5, preferably 1 to 4, particularly preferably 1 to 3 and very particularly preferably 1 to 2 quantum dots.

Very particularly preferably the formulation comprises one continuous and one discontinuous phase and one quantum dot.

The quantum dot(s) can be located in both the discontinuous and/or continuous phase. Preferably the quantum dot(s) is(are) located in the discontinuous phase of the formulation.

Another embodiment of the present invention relates to the above mentioned formulations comprising at least one continuous phase, at least one discontinuous phase and at least one functional surfactant, characterized in that the functional surfactant comprises at least one functional group and at least one group facilitating the formation of the formulation wherein the functional group is selected from host groups, emitter groups, hole injection groups, hole transport groups, hole blocking groups, electron injection groups, electron transport groups, electron blocking groups, exciton blocking groups, exciton formation groups, photoabsorption groups, dye groups, and metal complexes and additionally comprising at least one quantum dot, preferably 1 to 100, particularly preferably 1 to 50, and very particularly preferably 1 to 10 quantum dots.

Preference is given to such formulations comprising one continuous phase, one discontinuous phase and at least one functional surfactant, preferably 3, particularly preferably 2, and very particularly preferably 1 functional surfactant, and further comprising at least one quantum dot, preferably 1 to 100, particularly preferably 1 to 50, and very particularly preferably 1 to 10 quantum dots. Herein the term functional surfactant has the meaning as defined above.

Further preference is given to such formulations comprising one continuous phase, one discontinuous phase and at least one functional surfactant, preferably 3, particularly preferably 2, and very particularly preferably 1 functional surfactant(s), and further comprising at least one quantum dot, preferably 3, particularly preferably 2, and very particularly preferably 1 quantum dot(s).

The quantum dot(s) can be located either in the continuous phase or in the discontinuous phase.

The formulations comprising the functional surfactant(s) and quantum dot(s) can further comprise at least one further functional material selected from host materials, emissive materials (EM), hole injection materials (HIM), hole transport materials (HTM), hole blocking materials (HBM), electron injection materials (EIM), electron transport materials (ETM), electron blocking materials (EBM), exciton blocking materials (ExBM), photoabsorption materials, dyes, and metal complexes. The materials mentioned here are the same as described above.

If the formulation according to the present invention comprise quantum dot(s) it is preferred to have quantum dot(s) and emissive material in the same phase, i.e. either in the discontinuous phase or in the discontinuous phase. Preferably the formulation according to the present invention comprise fluorescent emitter(s) and quantum dot(s) in the same phase. Further preference is given to a formulation according to the present invention comprise phosphorescent emitter(s) and quantum dot(s) in the same phase.

However, in certain cases it is desirable to have emitter(s) and quantum dot(s) separated in different phases.

Quantum dots represent another class of emissive material. They are also called mono-dispersive nanocrystal as described below. The advantages of quantum dot are: 1) theoretical internal quantum efficiency as high as 100%, compared to 25% of the singlet organic emitter; 2) soluble in common organic solvents; 3) emission wavelength can be easily tuned by the core size; 4) narrow emission spectrum; 5) intrinsic stability in inorganic materials.

The first mono-dispersive nanocrystals including a semiconducting material, also referred to herein as quantum dots or QDs, were based on CdE (E=S, Se, Te) and were produced using the so called TOPO (trioctyl phosphine oxide) method by Bawendi and later modified by Katari et al. A review on synthesis of QDs is given by Murray, Norris and Bawendi, "Synthesis and characterization of nearly monodisperse CdE (E = sulfur, selen, tellurium) semiconductor nanocrystallites", J. Am. Chem. Soc. 115[19], 8706-8715, 1993. The mostly-reported caps of quantum dots are based on trioctylphosphine oxide (TOPO) or trioctylphosphine (TOP), which are supposed to have electron transporting properties.

Quantum dots can easily be produced and have a narrow emission spectrum in contrast to organic fluorescent or phosphorescent compounds. They can be tailored in terms of size which determines the quantum dot's emission maximum. High photoluminescent efficiency can also be obtained with quantum dots. Furthermore their emission intensity can be tailored by their concentration employed. Moreover, quantum dots are soluble in many solvents or can easily be made soluble in common organic solvents, allowing versatile processing methods, particularly printing methods such as screen printing, off-set printing, and ink jet printing.

In general, a quantum dot is a semiconductor whose excitons are confined in all three spatial dimensions. As a result, they have properties that are between those of bulk semiconductors and those of discrete molecules. There are several ways to prepare quantum dot structures, for example by chemical methods or by ion implantation, or in nanodevices made by state-of-the-art lithographic techniques.

The quatuim dots of the present invention refer to colloidal semiconductor nanocrystals, also known as colloidal quantum dots, or nanodots or nanocrystals, which are produced by chemical methods.

The term quantum dots (QDs) refers to nanocrystals that are substantially mono-disperive in size. A QD has at least one region or characteristic dimension with a dimension of less than about 500 nm, and down to on the order of less than about 1 nm. The term mono-dispersive means the size distribution is within +-10% of the stated value, for example a mono-dispersive nanocrystals of 100 nm in diameter encompasses a range of sizes from 90 nm or larger to 110 nm or smaller.

The concentration range of quantum dot(s) in the formulation can be chosen from: between 0.01 and 20 wt%, between 0.05 and 10 wt%, and between 0.1 and 5 wt%, referring to the total weight of the formulation.

The first mono-dispersive colloidal quantum dots including a semiconducting material were based on CdE (E = S, Se, Te) and were produced using the so called TOPO (trioctyl phosphine oxide) method by Bawendi and later modified by Katari et al. A review on synthesis of QDs is given by Murray, Norris and Bawendi, "Synthesis and characterization of nearly monodisperse CdE (E = sulfur, selen, tellurium) semiconductor nanocrystallites", J. Am. Chem. Soc. 115[19], 8706-8715, 1993.

While any method known to the skilled person can be used to create QDs, preferably a solution-phase colloidal method for controlled growth of inorganic QDs is used. The said colloidal methods are disclosed, e.g., by Alivisatos, A. P., "Semiconductor clusters, nanocrystals, and quantum dots," Science 271:933 (1996); X. Peng, M. Schlamp, A. Kadavanich, A. P. Alivisatos, "Epitaxial growth of highly luminescent CdSe/CdS Core/Shell nanocrystals with photostability and electronic accessibility," J. Am. Chem. Soc. 30:7019-7029 (1997); and C. B. Murray, D. J. Norris, M. G. Bawendi, "Synthesis and characterization of nearly monodisperse CdE (E=sulfur, selenium, tellurium) semiconductor nanocrystallites," J. Am. Chem. Soc. 115:8706 (1993). These methods allow low cost processability without the need for clean rooms and expensive manufacturing equipment. In these methods, metal precursors that undergo pyrolysis at high temperature are rapidly injected into a hot solution of organic surfactant molecules. These precursors break apart at high temperatures and react to nucleate nanocrystals. After this initial nucleation phase, a growth phase begins by the addition of monomers to the growing crystal. Thus, crystalline nanoparticles are obtained in solution that has an organic surfactant molecule coating their surface.

In these methods, synthesis occurs as an initial nucleation event that takes place over seconds, followed by crystal growth at elevated temperature for several minutes. Parameters such as the temperature, types of surfactants present, precursor materials, and ratios of surfactants to monomers can be modified so as to change the nature and progress of the reaction. The temperature controls the structural phase of the nucleation event, rate of decomposition of precursors, and rate of growth. The organic surfactant molecules mediate both solubility and control of the nanocrystal shape. The ratio of surfactants to monomer, surfactants to each other, monomers to each other, and the individual concentrations of monomers strongly influence the kinetics of growth.

In these methods, synthesis occurs as an initial nucleation event that takes place over seconds, followed by crystal growth at elevated temperature for several minutes. Parameters such as the temperature, types of surfactants present, precursor materials, and ratios of surfactants to monomers can be modified so as to change the nature and progress of the reaction. The temperature controls the structural phase of the nucleation event, rate of decomposition of precursors, and rate of growth. The organic surfactant molecules mediate both solubility and control of the nanocrystal shape. The ratio of surfactants to monomer, surfactants to each other, monomers to each other, and the individual concentrations of monomers strongly influence the kinetics of growth.

Suitable semiconducting materials, which can be incoporated into QDs, are selected from elements of Group II- VI, such as CdSe, CdS, CdTe, ZnSe, ZnO, ZnS, ZnTe, HgS, HgSe, HgTe and alloys thereof such as CdZnSe; Group III-V, such as InAs, InP, GaAs, GaP, InN, GaN, InSb, GaSb, AlP, AlAs, AlSb and alloys such as InAsP, CdSeTe, ZnCdSe, InGaAs; Group IV-VI, such as PbSe, PbTe and PbS and alloys thereof; Group III-VI, such as InSe, InTe, InS, GaSe and alloys such as InGaSe, InSeS; Group IV semiconductors, such as Si and Ge alloys thereof, and combinations thereof in composite structures.

Further suitable semiconductor materials include those disclosed in U.S. patent application Ser. No. 10/796,832 and include any type of semiconductor, including group II-VI, group III-V, group IV-VI and group IV semiconductors. Suitable semiconductor materials include, but are not limited to, Si, Ge, Sn, Se, Te, B, C (including diamond), P, BN, BP, BAs, AlN, AlP, AlAs, AlS, AlSb, BaS, BaSe, BaTe, CaS, CaSe, CaTe, GaN, GaP, GaAs, GaSb, InN, InP, InAs, InSb, AlN, AlP, AlAs, AlSb, GaN, GaP, GaAs, GaSb, ZnO, ZnS, ZnSe, ZnTe, CdS, CdSe, CdTe, HgS, HgSe, HgTe, BeS, BeSe, BeTe, MgS, MgSe, GeS, GeSe, GeTe, SnS, SnSe, SnTe, PbO, PbS, PbSe, PbTe, CuF, CuCl, CuBr, CuI, Si₃N₄, Ge₃N₄, Al₂O₃, (Al, Ga, In)₂ (S, Se, Te)₃, and Al₂CO. Furthermore, further suitable semiconductor materials include combinations of the aforementioned semiconductors and/or combinations with core/shell, core multi-shell layered structures.

The present invention also relates to a method for the preparation of a formulation according to the present invention comprising the following steps:
(a) preparing a first solution comprising at least one first further functional material in at least one first solvent, and at least one functional surfactant;
(b) preparing a second solution comprising at least one second functional material in at least one second solvent;
(c) mixing the first solution obtained in step (a) and the second solution obtained in step b) in a specific ratio;
(d) forming a formulation from the mixture obtained in step (c) by a physical method.

Preferably the formulation is obtained by applying a high shear force, whereby the preferred physical technique to be used in step (d) for this purpose is ultrasonication.

A preferred ratio is in the range of 3:1 to 15:1 in weight. One preferred first solvent is water and/or alcohol.

The suitable second organic solvent can be selected from the organic solvents as described elsewhere in the present invention. Preferably, the weight concentration of the functional materials in the second solution is from 0.5 to 10%, preferably 1 to 5%, particularly preferably 2 to 4%.

Preferably, the weight concentration of the functional materials in the first solution is from 0.5 to 10%, preferably 1 to 5%, particularly preferably 2 to 4%.

In a further embodiment of the present invention step d) is conducted by ultrasonic treatment or a high pressure homogenisator or a jet disperser, preferably by ultrasonic treatment.

Yet another embodiment of the present invention relates to a method for the preparation of a formulation which is an water-in-oil emulsion comprising similar steps as described above, wherein the first solution is an organic solvent comprising at least one first functional material with optionally a surfactant, and the second solution is a water and/or alcohol solution comprising at least one second functional material.

The formulation may also comprise at least one suitable further non-functional surfactant. Preferably sodium dodecylsulfate (SDS) is used. The amount of further non-functional surfactant(s) is preferably in the range from 0.1 to 10 wt%, particularly preferably from 0.2 to 5 wt%, and very particularly preferably from 0.5 to 2 wt%, based on the overall weight of the formulation.

Suitable further non-functional surfactants that can be used for the formulations according to the present invention are selected from anionic surfactants, nonionic surfactants, cationic surfactants, zwitterionic surfactants, amphoteric surfactants, or combinations thereof.

Preferably, the formulation according to the invention comprises at least one, preferably 3, particularly preferably 2, and very particularly preferably 1 further non-functional surfactants. Further non-functional surfactants can be used to stabilise the emulsion.

Non-limiting examples of anionic surfactants suitable for use herein include alkyl and alkyl ether sulfates, sulfated monoglycerides, sulfonated olefins, alkyl aryl sulfonates, primary or secondary alkane sulfonates, alkyl sulfosuccinates, acyl taurates, acyl isethionates, alkyl glycerylether sulfonate, sulfonated methyl esters, sulfonated fatty acids, alkyl phosphates, acyl glutamates, acyl sarcosinates, alkyl sulfoacetates, acylated peptides, alkyl ether carboxylates, acyl lactylates, anionic fluorosurfactants, sodium lauroyl glutamate, and combinations thereof

Anionic surfactants suitable for use according to the present invention include alkyl and alkyl ether sulfates. These materials have the respective formulae ROSO₃M and RO(C₂H₄O)ₓSO₃M, wherein R is alkyl or alkenyl of from about 8 to about 24 carbon atoms, x is 1 to 10, and M is a watersoluble cation such as ammonium, sodium, potassium and triethanolamine. The alkyl ether sulfates are typically made as condensation products of ethylene oxide and monohydric alcohol's having from about 8 to about 24 carbon atoms. Preferably, R has from about 10 to about 18 carbon atoms in both the alkyl and alkyl ether sulfates. The alcohols can be derived from fats, e. g., coconut oil or tallow, or can be synthetic. Lauryl alcohol and straight chain alcohol's derived from coconut oil are preferred herein. Such alcohol's are reacted with about 1 to about 10, preferably from about 3 to about 5, and particularly preferably about 3, molar proportions of ethylene oxide and the resulting mixture of molecular species having, for example, an average of 3 moles of ethylene oxide per mole of alcohol, is sulfated and neutralized.

Specific examples of alkyl ether sulfates which may be used according to the present invention are sodium and ammonium salts of coconut alkyl triethylene glycol ether sulfate; tallow alkyl triethylene glycol ether sulfate, and tallow alkyl hexaoxyethylene sulfate. Highly preferred alkyl ether sulfates are those comprising a mixture of individual compounds, said mixture having an average alkyl chain length of from about 10 to about 16 carbon atoms and an average degree of ethoxylation of from about 1 to about 4 moles of ethylene oxide.

Preferred anionic surfactants for use according to the present invention include ammonium lauryl sulfate, ammonium laureth sulfate, triethylamine lauryl sulfate, triethylamine laureth sulfate, triethanolamine lauryl sulfate, triethanolamine laureth sulfate, monoethanolamine lauryl sulfate, monoethanolamine laureth sulfate, diethanolamine lauryl sulfate, diethanolamine laureth sulfate, lauric monoglyceride sodium sulfate, sodium lauryl sulfate, sodium laureth sulfate, potassium lauryl sulfate, potassium laureth sulfate, sodium lauryl sarcosinate, sodium lauroyl sarcosinate, lauryl sarcosine, cocoyl sarcosine, ammonium cocoyl sulfate, ammonium lauroyl sulfate, sodium cocoyl sulfate, sodium lauroyl sulfate, potassium cocoyl sulfate, potassium lauryl sulfate, triethanolamine lauryl sulfate, triethanolamine lauryl sulfate, monoethanolamine cocoyl sulfate, monoethanolamine lauryl sulfate, sodium dodecyl sulfate, sodium tridecyl benzene sulfonate, sodium dodecyl benzene sulfonate, and combinations thereof.

Particularly preferred anionic surfactants are selected from alkyl sulfates, alkylbenzyl sulfates, alkyl sulfonates, alkylbenzyl sulfonates, alkyl phosphates, alkyl phosphonates, and alkyl carboxylates, particularly preferably sodium deodecyl sulphate (SDS).

Amphoteric surfactants suitable for use according to the present invention includes those that are broadly described as derivatives of aliphatic secondary and tertiary amines in which the aliphatic radical can be straight or branched chain and wherein one of the aliphatic substituents contains from about 8 to about 18 carbon atoms and one contains an anionic water solubilizing group, e.g., carboxy, sulfonate, sulfate, phosphate, or phosphonate. Examples of compounds falling within this definition are sodium 3-dodecyl-aminopropionate, sodium 3-dodecylaminopropane sulfonate, sodium lauryl sarcosinate, N-alkyltaurines such as the one prepared by reacting dodecylamine with sodium isethionate according to the teaching of US 2658072, N-higher alkyl aspartic acids such as those produced according to the teaching of US 2438091, and the products described in US 2528378.

Cationic surfactants can also be used according to the present invention. Preferred cationic surfactants are selected from cetyl trimethylammonium bromide (CTAB) and other alkyltrimethylammonium salts, cetylpyridinium chloride (CPC), polyethoxylated tallow amine (POEA), benzalkonium chloride (BAC), and benzethonium chloride (BZT).

Suitable nonionic surfactants for use according to the present invention include those described in McCutcheion's Detergents and Emulsifiers, North American edition (1986), Allured Publishing Corp., and McCutcheion's Functional Materials, North American edition (1992), which descriptions are incorporated herein by reference. These nonionic surfactants suitable for use herein include alkyl glucosides, alkyl polyglucosides, polyhydroxy fatty acid amides, alkoxylated fatty acid esters, sucrose esters, amine oxides, and combinations thereof.

Suitable nonionic surfactants for use according to the present invention include condensation products of alkylene oxide groups (hydrophilic in nature) with an organic hydrophobic compound, which may be aliphatic or alkyl aromatic in nature. Preferred classes of nonionic surfactants include:
1) polyethylene oxide condensates of alkyl phenols, e.g., the condensation products of alkyl phenols having an alkyl group containing from about 6 to about 20 carbon atoms in either a straight chain or branched chain configuration, with ethylene oxide, the ethylene oxide being present in amounts equal to from about 10 to about 60 moles of ethylene oxide per mole of alkyl phenol;
2) nonionic surfactants derived from the condensation of ethylene oxide with the product resulting from the reaction of propylene oxide and ethylene diamine products;
3) condensation products of aliphatic alcohol's having from about 8 to about 18 carbon atoms, in either straight chain or branched chain configuration, with ethylene oxide, e.g., a coconut alcohol ethylene oxide condensate having from about 10 to about 30 moles of ethylene oxide per mole of coconut alcohol, the coconut alcohol fraction having from about 10 to about 14 carbon atoms;
4) long chain tertiary amine oxides;
5) long chain tertiary phosphine oxides;
6) long chain dialkyl sulfoxides containing one short chain alkyl or hydroxy alkyl radical of from about 1 to about 3 carbon atoms (usually methyl) and one long hydrophobic chain which include alkyl, alkenyl, hydroxy alkyl, or keto alkyl radicals containing from about 8 to about 20 carbon atoms, from 0 to about 10 ethylene oxide moieties and from 0 to about 1 glyceryl moiety;
7) alkyl polysaccharide (APS) surfactants such as the alkyl polyglycosides, as described in US 4565647, which have a hydrophobic group with about 6 to about 30 carbon atoms and polysaccharide (e.g., polyglycoside) as the hydrophilic group, and optionally have a polyalkylene-oxide group joining the hydrophobic and hydrophilic moieties, wherein the alkyl group (i.e., the hydrophobic moiety) can be saturated or unsaturated, branched or unbranched, and unsubstituted or substituted (e. g., with hydroxy or cyclic rings); and
8) polyethylene glycol (PEG) glyceryl fatty esters, such as those of the formula R(O)OCH 2CH(OH)CH₂(OCH₂CH₂)ₙOH wherein n is from about 5 to about 200, preferably from about 20 to about 100, and R is an aliphatic hydrocarbyl having from about 8 to about 20 carbon atoms.

Zwitterionic surfactants suitable for use according to the present invention include those that are broadly described as derivatives of aliphatic quaternary ammonium, phosphonium, and sulfonium compounds, in which the aliphatic radicals can be straight or branched chain, and wherein one of the aliphatic substituents contains from about 8 to about 18 carbon atoms and one contains an anionic group, e.g., carboxy, sulfonate, sulfate, phosphate, or phosphonate.

Other zwitterionic surfactants suitable for use herein include betaines, including high alkyl betaines such as coco dimethyl carboxymethyl betaine, cocoamidopropyl betaine, cocobetaine, lauryl amidopropyl betaine, oleyl betaine, lauryl dimethyl carboxymethyl betaine, lauryl dimethyl alphacarboxyethyl betaine, cetyl dimethyl carboxymethyl betaine, lauryl bis-(2-hydroxyethyl)carboxymethyl betaine, stearyl bis-(2-hydroxypropyl) carboxymethyl betaine, oleyl dimethyl gamma-carboxypropyl betaine, and lauryl bis-(2-hydroxypropyl)alpha-carboxyethyl betaine. The sulfobetaines may be represented by coco dimethyl sulfopropyl betaine, stearyl dimethyl sulfopropyl betaine, lauryl dimethyl sulfoethyl betaine, lauryl bis-(2-hydroxyethyl)sulfopropyl betaine and the like; amidobetaines and amidosulfobetaines, wherein the RCONH(CH₂)₃ radical is attached to the nitrogen atom of the betaine are also useful in this invention.

The formulation according to the invention may further comprise at least one co-stabilizer. Hydrophobic compounds used as co-stabilizers osmotically stabilize the formulation according to the invention against Ostwald ripening.

Suitable co-stabilizers (e.g., silanes, organo silanes, siloxanes and long chain esters) as disclosed in DE 198 52 784 may be used in the formulation according to the invention.

Preferably the formulation according to the present invention is an emulsion, wherein both the continuous phase(s) and the discontinuous phase(s) comprise at least one solvent.

In another preferred embodiment of the present invention the formulation is a dispersion, wherein at least one nanodroplet represents a solid nanoparticle which is dispersed in the continuous phase. The dispersion can be obtained, e.g., by removing the solvent or solvents from the discontinuous phase as outlined elsewhere within this invention.

Formulations according to the present invention can be used for the preparation of a layer and multilayer structure in order to establish a stack of functional materials, e.g. for the preparation of electronic or opto-electronic devices such as OLEDs. For further processing it is sometimes advantageous to remove the solvent(s) from one or more discontinuous phases before coating, which results in a formulation which is a dispersion comprising the continuous phase(s) and the discontinuous phase(s) comprising the functional material(s) as solid nanoparticles in at least one of the discontinuous phase dispersed in the continuous phase(s).

Therefore, the present invention also relates to a dispersion, characterized in that the dispersion comprises nanoparticles dispersed in a continuous phase formed by removing the solvent of the discontinuous phase of the emulsion according to the present invention. The nanodroplets of the emulsion according to the present invention are, thus, converted into a solid nanoparticles which are dispersed in the continuous phase(s) of the formulation. The term dispersion is used herein for a system comprising at least one liquid media (e.g. an aqueous or alcohol-based phase) and an phase suspended as solid particle, preferably as nanoparticles.

The present invention also relates to a dispersion comprising nanoparticles dispersed in the continuous phase(s) of the formulations according to the present invention, characterized in that the nanoparticles comprise at least one functional material and in that the continuous phase also comprises at least one functional material.

Preferably the nanoparticles comprise 3, particularly preferably 2, and very particularly preferably 1 functional materials.

If a further non-functional surfactant is present in the formulation it is, at least in part, removed.

Any formulation according to the present invention can be either an emulsion or dispersion. Any of the emulsions according to the present invention can be converted into a dispersion.

Layer structures are crucial for various organic electronic or opto-electronic devices. The present invention further relates to a method for preparing a layer structure using orthogonal solvents by making use of the formulation, i.e. the emulsion and/or the dispersion, according to the present invention. The formulations according to the present invention can be used in various ways to prepare a layer structure. Preferably the layer structure is a multilayer structure.

The preferred ways are described as below:
The first method comprises the following steps:
   (a) prepare the first organic layer on a substrate;
   (b) prepare the second organic layer above the first organic layer by coating a formulation (i.e. emulsion or dispersion) according to the present invention; characterised in that the first organic layer is insoluble or has a limited solubility in the solvent in the continuous phase of the said emulsion or dispersion

In the said first method, the first layer can either be deposited by thermal evaporation or (preferably) be coated from solution, for example by spin-coating, ink-jet printing, screen printing, slot printing, nozzle printing, etc. In the step (b), it is important that the first organic layer is insoluble or has only a limited solubility in the solvent in the continuous phase of the said emulsion or dispersion, so that the first layer is still closed after coating the emulsion or the dispersion. Preferably, the maximal solubility of the first layer is less than 0.4 wt% at the working temperature in the solvent of the continuous phase of said emulsion or dispersion. And most preferably the first layer is insoluble in the solvent of the continuous phase of said emulsion or dispersion.

The second method comprises the following steps:
(a) prepare the first organic layer on a substrate by coating a formulation (i.e. emulsion or dispersion) according to the present invention;
(b) prepare the second organic layer above the first organic layer from a second solution;
characterised in that the first functional material in the first organic layer is insoluble or has a limited solubility in the solvent of the second solution.

In the said second method, both layers are coated from solution by a coating technique, which can be selected from spin-coating, or printing techniques such as ink-jet printing, screen printing, slot printing, nozzle printing, etc. In the step (b), it is essentially that the first organic layer has only a limited solubility in the solvent of the second solution, so that the first layer is still closed after coating the emulsion or the dispersion. Preferably, the maximal solubility of the first layer is less than 0.4wt% at the working temperature in the solvent of the continuous phase of said emulsion or dispersion. And most preferably the first layer is insoluble in the solvent of the second solution.

The third method comprises the following steps:
(a) prepare the first organic layer on a substrate by coating a formulation (i.e. emulsion or dispersion) according to the present invention;
(b) prepare the second organic layer above the first organic layer from a second or a second dispersion according to the present invention;
characterised in that the first functional material in the first organic layer is insoluble or has a limited solubility in the solvent of the continuous phase of the second emulsion or dispersion.

In the said third method, both layers are coated from solution by a technique selected from spin-coating, or printing techniques such as ink-jet printing, screen printing, slot printing, nozzle printing, etc. In the step (b), it is essentially that the first organic layer has only a limited solubility in the solvent in the continuous phase of the said emulsion or dispersion, so that the first layer is still closed after coating the emulsion or the dispersion. Preferably, the maximal solubility of the first layer is less than 0.4 wt% at the working temperature in the solvent of the continuous phase of said emulsion or dispersion. And most preferably the first layer is insoluble in the solvent of the continuous phase of said emulsion or dispersion.

In a very preferred embodiment, the methods as described above for preparing a multilayer structure use a dispersion as coating media.

In a further preferred embodiment of the present invention the method for the preparation of a multi layer structure as described above is characterized in that at least one additive is added to the dispersion.

Preferably 3, particularly preferably 2, and very particularly preferably 1 additive is added to the dispersion.

The preferred function of the additive is the modification of physical properties in order to facilitate the preparation of multi layer structures.

Particularly preferably the additive modifies the surface tension of the dispersion in order to enable film formation. A typical problem in context with the preparation of a multilayer structure using orthogonal solvents is the wetting of the solution or dispersion on the underneath layer. Therefore, it is necessary to modify the solution or dispersion, for example its surface tension, before its use. It can be achieved by adding additional additives, for example wetting agents, dispersing agents, hydrophobing agents, adhesive agents etc. Further suitable additive can be referred to for example WO 2003/019693 A2.

The important parameters for deposition techniques from solution or dispersion are for example viscosity, surface tension, concentration, molecular weight of the solution, and particle size of the dispersion, boiling point of solvent, etc.. Indeed, different deposition techniques demand different parameters. For the most widely used techniques, spin-coating and inkjet printing, they have some parameters in common; for example, they demand a viscosity of 4 to12 mPas, and surface tension < 40 mN/m, particles with a size of ≤ 1 µm, and boiling point of solvent from 70 to 190°C, though the optimal condition may be different from each other depending on the method and the substrate used.

It is important to adjust the above mentioned parameter of the solution or dispersion in a desired corridor. This can be achieved by adding different additives. However, the additive will be left in the film, which is not desired. Surprisingly, the physical parameters as described above can be appropriately modified by using a suitable co-solvent, which is miscible with the solvent of the solution or dispersion, but not necessary a solvent for the solute of the solution or the organic functional materials in the discontinuous phase of the dispersion. For coating water-based dispersion of the present invention on an organic layer, the suitable co-solvent should fulfil either 1) surface tension in range of 10 to 40 mPas or 2) a boiling point from 70 to 200°C, and a particularly suitable co-solvent should fulfil both conditions. A good example for the suitable co-solvent for the water-based dispersion of the present invention is iso-propanol (see working examples).

Therefore, a preferred additive is a co-solvent, particularly preferably an alcohol, and very particularly preferably iso-propanol.

In further another embodiment, the present invention relates to a coating method using the emulsion and/or dispersion as described above and below. It is desirable to generate small structures or patterns in modern microelectronics to reduce cost (more devices/unit area), and power consumption. Patterning of the layer of the invention may be carried out, for example, by photolithography, electron beam lithography, nano-imprint lithography (as reported for example in Science (96), 272, 85-87), or "Dip-Pen" Nanolithography (as reported in Science (99), 283, 661-663). For use as thin layers in electronic or opto-electronic devices the organic functional materials or an emulsion or dispersion according to the present invention may be deposited by any suitable method. Liquid coating of devices such as OLEDs is more desirable than vacuum deposition techniques. Solution deposition methods are especially preferred. Preferred deposition techniques include, without limitation, dip coating, spin coating, ink jet printing, letter-press printing, screen printing, doctor blade coating, roller printing, reverse-roller printing, offset lithography printing, flexographic printing, web printing, spray coating, brush coating or pad printing, slot-die coating. Ink-jet printing is particularly preferred as it allows high resolution displays to be prepared.

Selected emulsions and /or dispersions according to the present invention may be applied to prefabricated device substrates by ink jet printing or microdispensing. Preferably industrial piezoelectric print heads such as but not limited to those supplied by Aprion, Hitachi-Koki, InkJet Technology, On Target Technology, Picojet, Spectra, Trident, Xaar may be used to apply the organic functional material layer to a substrate. Additionally semi-industrial heads such as those manufactured by Brother, Epson, Konica, Seiko Instruments Toshiba TEC or single nozzle microdispensers such as those provided by Microdrop and Microfab may be used.

In order to be applied by ink jet printing or microdispensing, the emulsion and /or dispersion according to the present invention should be first prepared in a suitable solvent in the continuous phase. Solvents must fulfil the requirements stated above and must not have any detrimental effect on the chosen print head. In the case of water-based or other polar solvent-based emulsion, the use of such emulsions or dispersions are known in conjunction with desktop inkjet printers. For inverse emulsions and dispersion thereof, where the continuous phase is non-polar, solvents should have boiling points >100°C, preferably >140°C and more preferably >150°C in order to prevent operability problems caused by the solution drying out inside the print head. Apart from the solvents already disclosed herein, suitable solvents include substituted and non-substituted xylene derivatives, di-C1-2-alkyl formamide, substituted and non-substituted anisoles and other phenol-ether derivatives, substituted heterocycles such as substituted pyridines, pyrazines, pyrimidines, pyrrolidinones, substituted and non-substituted N,N-di-C1-2-alkylanilines and other fluorinated or chlorinated aromatics.

A preferred solvent for depositing an inverse emulsion and dispersion thereof according to the present invention by ink jet printing comprises a benzene derivative which has a benzene ring substituted by one or more substituents wherein the total number of carbon atoms among the one or more substituents is at least three. For example, the benzene derivative may be substituted with a propyl group or three methyl groups, in both cases there are three substituting carbon atoms in total. Such a solvent enables an ink jet fluid to be formed comprising the solvent with the polymer, which reduces or prevents clogging of the jets and separation of the components during spraying. The solvent(s) may include those selected from the following list of examples: dodecylbenzene, 1-methyl-4-tert-butylbenzene, terpineol limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer. The ink jet fluid (that is an emulsion according to present invention) preferably has a viscosity at 20°C of 1 to 100 mPa.s, more preferably 1 to 50 mPa.s and most preferably 1 to 30 mPa.s.

Another subject of the present invention relates to the use of the formulations according to the present invention for the preparation of electronic and opto-electronic devices

Use of a method according to one or more of claims 13 to 15 for the preparation of electronic and opto-electronic devices.
Another subject of the present invention relates to the use of the methods for the preparation of layer structures according to the present invention for the preparation of electronic and opto-electronic devices.

Preference is given to the use of formulations, i.e. emulsions and/or dispersions, according to the present invention in electronic and opto-electronic devices selected from organic light emitting diodes (OLEDs), polymer light emitting diodes (PLEDs), fiber OLEDs, organic light emitting electrochemical cells (OLECs), organic field effect transistors (OFETs), thin film transistors (TFTs), organic solar cells (O-SCs), dye-sensitised solar cells (DSSCs), organic laser diodes (O-laser), organic integrated circuits (O-IC), radio frequency identification (RFID) tags, photodetectors, sensors, logic circuits, memory elements, capacitors, charge injection layers, Schottky diodes, planarising layers, antistatic films, conducting substrates or patterns, photoconductors, electrophotographic elements, organic light emitting transistors (OLETs), organic spintronic devices, and organic plasmon emitting devices (OPEDs).

The invention further relates to an electronic or opto-electronic device obtained by a method according to the invention. Preferably the device is selected from organic light emitting diodes (OLEDs), polymer light emitting diodes (PLEDs), fiber OLEDs, organic light emitting electrochemical cells (OLECs), organic field effect transistors (OFETs), thin film transistors (TFTs), organic solar cells (O-SCs), dye-sensitised solar cells (DSSCs), organic laser diodes (O-laser), organic integrated circuits (O-IC), radio frequency identification (RFID) tags, photodetectors, sensors, logic circuits, memory elements, capacitors, charge injection layers, Schottky diodes, planarising layers, antistatic films, conducting substrates or patterns, photoconductors, electrophotographic elements, organic light emitting transistors (OLETs), organic spintronic devices, and organic plasmon emitting devices (OPEDs). Particularly preferably the device is a OLED, and an O-SCs.

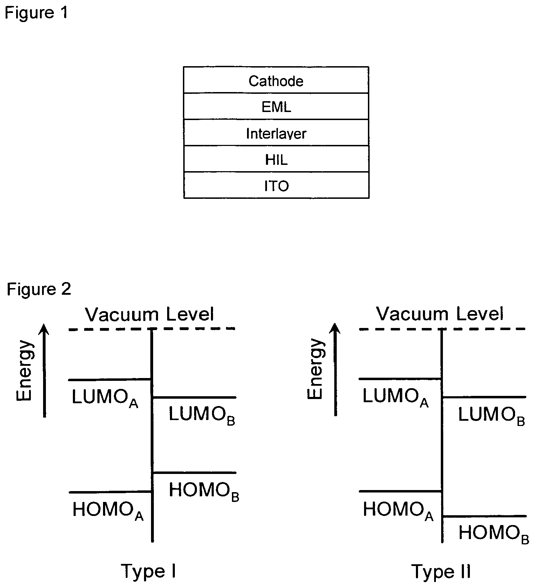

It is usually an advantage to have a plurality of organic functional materials within a device, either in the same layer or in two adjacent layers, forming a heterojunction either in between the layers or a bulk heterojunction in the layer (see Figure 2). Analogously to inorganic semiconductors such heterojunctions can be classified into 2 classes: type I, in which the LUMO and HOMO levels of one material (material A) lie within the LUMO-HOMO energy gap of the second material (material B), as illustrated on the left hand side of Figure 2, and type II, in which the minimum energy difference between the highest HOMO state and the lowest LUMO state is between levels on different sides of the heterojunction, as illustrated on the right hand side of Figure 1. Electrons tend to occupy the energetically lowest LUMO level, whereas holes tend to occupy the energetically highest HOMO level. Thus, in a type I heterojunction electrons and holes are located on the same side of the junction and in a type II heterojunction both electrons and holes are located on different sides of the junction. However, because in organic functional materials, the exciton binding energy is usually assumed to be 0.5 eV or more, the band offset of type II is necessarily bigger than about 0.5 eV to ensure the efficient excition dissociation at the heterojunction, which is an important issue particularly for organic solar cells.

Preference is given to an OLED which is prepared by using at least one emulsion or dispersion according to the present invention, wherein said emulsion or dispersion comprises at least one organic functional material as outlined above.

A typical sequence of layers as found in an OLED and O-SC is, for example:
- optionally a first substrate,
- an anode layer,
- optionally a hole injection layer (HIL),
- optionally a hole transport layer (HTL) and/or an electron blocking layer (EBL),
- an active layer, which upon electrical or optical exciation, produces excitons,
- optionally an electron transport layer (ETL) and/or a hole blocking layer (HBL),
- optionally an electron injection layer (EIL),
- a cathode layer,
- optionally a second substrate.

The sequence of the given layer structure is exemplary. Other sequences are possible. Depending on the active layers in the above mentioned device, different opto-electronic devices will be obtained. In a first preferred embodiment, the active layer generates excitons upon electrical excitation through applying voltage between anode and cathode, and further emits light through radiative decay of the excitons. In general, this is called light emitting device. In another preferred embodiment, the active layer generates exciton through absorbing light, and further produces free charge carrier through exciton dissociation. In general, this is called photovoltaic or solar cell.

The term interlayer as used herein is defined as layer between the hole injection layer (or buffer layer) and the emissive layer in polymer light emitting diodes (PLEDs), being an electron blocking layer, as disclosed for example in WO 2004/084260 A2. The typical device structure of PLEDs with interlayer is shown in Figure 2. However one problem with this kind of device is that the interlayer is usually, at least in part, washed away upon coating the EML layer, which leads to a very thin layer. This process is not well-controlled in the prior art. It is highly desired to use ETL or HMB in PLEDs, as shown in Figure 3, in order to get better confinement of holes and exciton in the EML to achieve high efficiency and lifetime.

In another preferred embodiment, the electronic device of the invention is soluble system based OLEDs, particularly PLEDs as disclosed for example in WO 2004/084260 A2, which comprises the multilayer structure as follows: anode/HIL/EML/Cathode, wherein the double-layer HIL/EML is made by using at leat one dispersion and one method for multilayer structure as described above.

The HIL is usually a transparent conductive polymer thin film comprising HIM. Preferred HIM are those mentioned above. The emissive materials may further comprise a blend or mixture of two or more different emitters, for example two emitters of different type and/or emitters that emit light of different colors. Thus, a device of the present invention may provide white light.

The device structure of the above mentioned further electronic device is clear to the skilled person in the art in the field. Nevertheless, for the sake of clarity, references are made to some detailed device structures. Organic Plasmon emitting device is preferably referred to the device as reported by Koller et al., in Nature Photonics (2008), 2, 684-687. The OPED is very similar as OLED as described above, except that at least one of anode and cathode should be capable to couple surface Plasmon from the emissive layer. It is preferred here that an OPED is prepared by using an emulsion or dispersion and the methods described herein.

One preferred organic spintronic device is a spin-valve device, as reported, e.g., by Z.H. Xiong et al., in Nature 2004, Vol. 427, 821, comprising two ferromagnetic electrodes and an organic layer between the two ferromagnetic electrodes. The ferromagnetic electrode is composed of Co, Ni, Fe, or alloys thereof, or ReMnO₃ or CrO₂, wherein Re is rare earth element. It is preferred that at least one of the organic layer is coated from an emulsion or dispersion according the present invention.

Organic light emitting electrochemical cells. (OLECs) comprise two electrodes, and a mixture or blends of electrolyte and fluorescent species in between, as firstly reported by Pei & Heeger in Science (1995), 269, 1086-1088. I It is preferred here that an OLEC is prepared by using an emulsion or dispersion and the methods described above and below.

Dye-sensitized solar cells (DSSCs) comprise, in the sequence, an electrode/dye-sensitized TiO₂ porous thin film/electrolyte/counter electrode, as firstly reported by O'Regan & Grätzel in Nature (1991), 353, 737-740. The liquid electrolyte can be replaced by a solid hole transport layer, as reported in Nature (1998), 395, 583-585.

The layer of a device prepared according to the teaching of the present invention have, due to the particle-related structure of the nanoparticles in dispersions or nanodroplets in emulsions a particular structure. This particular nano-structure, in turn, tremendously determines the structure of the corresponding layer and the beneficial opto-electronic characteristics of the layer itself and of the device as a whole. The present invention relates also to layer and multilayer structures obtainable by the use of a formulation according to the present invention. The present invention also relates to devices comprising said layer. Preferably the devices are opto-electronic devices as outlined elsewhere in the present invention.

The present invention also relates to devices obtainable by the use of a formulation according to the present invention.

Functional surfactant, characterized in that it comprises at least one functional group and at least one group facilitating the formation of a continuous and a discontinuous phase wherein the functional group is selected from host groups, phosphorescent emitter groups, hole injection groups, hole transport groups, hole blocking groups, electron injection groups, electron transport groups, electron blocking groups, exciton blocking groups, exciton formation groups, photoabsorption groups, dye groups, and metal complexes, are also subject of the present invention.

Preferably the functional group is selected from host groups, phosphorescent emitter groups, hole injection groups, hole transport groups, hole blocking groups, electron injection groups, electron transport groups, electron blocking groups, exciton blocking groups, exciton formation groups, photoabsorption groups, dye groups, and metal complexes.

Preference is given to functional groups selected from host groups. Further preference is given to functional groups selected from emitter groups. Further preference is given to functional groups selected from phosphorescent emitter groups. Further preference is given to functional groups selected from fluorescent emitter groups. Further preference is given to functional groups selected from hole injection groups. Further preference is given to functional groups selected from hole transport groups. Further preference is given to functional groups selected from hole blocking groups. Further preference is given to functional groups selected from electron injection groups. Further preference is given to functional groups selected from electron transport groups. Further preference is given to functional groups selected from electron blocking groups. Further preference is given to functional groups selected from exciton blocking groups. Further preference is given to functional groups selected from exciton formation groups. Further preference is given to functional groups selected from photoabsorption groups. Further preference is given to functional groups selected from dye groups. Further preference is given to functional groups selected from metal complexes.

The functional groups can be selected from any functional material as described elsewhere within the present invention. The functional materials according the present invention have an amphiphilic nature, which can be realised by functionalizing the material with at least one group having a polarity which may be different from the functional group. Preferably the group is more hydrophilic as compared to the functional group. Particularly preferably the functional material can comprise an additional hydrophobic group. The functionalization is further described elsewhere in the present invention.

Preference is given to a functional surfactant comprising a host group, characterized in that the host groups is selected from anthracenes, benzanthracenes, ketones, carbazoles, triarylamines, indenofluorenes, fluorenes, spirobifluorenes, phenanthrenes, dihydrophenanthrenes, thiophenes, triazines, isomers and derivatives thereof.

The functional surfactant according the present invention is characterized in that the functional surfactant comprises one group facilitating the formation of a miniemulsion selected from the groups as outlined elsewhere within the present invention.

The formulations (dispersions, emulsions) of the present invention, devices comprising them and devices obtainable by using the said formulations can be used for any kind of light sources, which includes, but is not limited to, lightening and display applications. Light sources play also a crucial role in many therapeutic, cosmetic, prophylactic, and diagnostic applications. In some applications the function of light sources is solely directed to illuminate a display or the subject to be treated. In other cases the beneficial effect of light is exploited when human or animal subjects are treated. Thus, formulations, i.e. both emulsions and dispersions, according to the present invention can be used for the treatment, prophylaxis, and or diagnosis of therapeutic diseases and/or cosmetic conditions. This includes any kind of phototherapy, photodynamic therapy, and any combination of light therapy and therapies not using light such as drug therapies, commonly referred herein as to light therapy or light treatment. Many light treatments are directed to outer surfaces of the subject to be treated such as skin, wounds, mucosa, eye, hair, nail, nail beds, and gingival, and tongue, but light treatment can also be applied inside the subject in order to treat, e.g., the lungs, blood vessels, heart, breast, and other organs of the subject.

These diseases and/or conditions include, e.g., skin diseases, and skin-related conditions including skin-ageing, and cellulite, enlarged pores, oily skin, folliculitis, precancerous solar keratosis, skin lesion, aging, wrinkled and sun-damaged skin, crow's feet, skin ulcers (diabetic, pressure, venous stasis), acne rosacea lesions, cellulite; photomodulation of sebaceous oil glands and the surrounding tissues; reducing wrinkles, acne scars and acne bacteria, inflammation, pain, wounds, psychological and neurological related diseases and conditions, edema, Pagets disease, primary and metastatic tumors, connective tissue disease, manipulation of collagen, fibroblast, and fibroblast derived cell levels in mammalian tissue, illuminating retina, neoplastic, neovascular and hypertrophic diseases, inflammation and allergic reactions, perspiration, sweating and hyperhydrosis from eccrine (sweat) or apocrine glands, jaundice, vitiligo, ocular neovascular diseases, bulimia nervosa, herpes, seasonal affective disorders, mood, sleep disorders, skin cancer, crigler naijar, atopic dermatitis, diabetic skin ulcers, pressure ulcers, bladder infections, relief of muscular pains, pain, stiffness of joints, reduction of bacteria, disinfection, disinfection of liquids, disinfection of beverages such as water, disinfection of nutrition, gingivitis, whitening teeth, treatment of teeth and tissue in mouth, wound healing.

The said formulations, devices comprising them, and devices obtainable by the use of formulations according to the present invention comprise at least one organic electroluminescent compound which emits light in the range between 200 and 1000 nm, preferably between 300 and 1000 nm, particularly preferably between 300 and 950 nm, and very particularly preferably between 400 and 900 nm.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed. The teaching as disclosed here can be abstracted und combined with other examples disclosed.

Other features of the invention will become apparent in the course of the following description of exemplary embodiments and drawings, which are given for illustration of the invention and are not intended to be limiting thereof.

### Brief Description of the Drawings

Figure 1: Typical layer structure of an OLED comprising cathode, EML, interlayer, HIL, and ITO (anode).
Figure 2: Orbital energy schema of Type I and Type II heterojunctions.

### Working Examples

### Example 1

### Materials

The following polymer IL1 can be synthesized by employing the Suzuki coupling. The reaction can be carried out according to synthetic methods well known to the person skilled in the art. The method is described, e.g., in WO 2003/048225.

Polymer IL1, used as interlayer, is the copolymer comprising the following monomers with mol% as indicated:

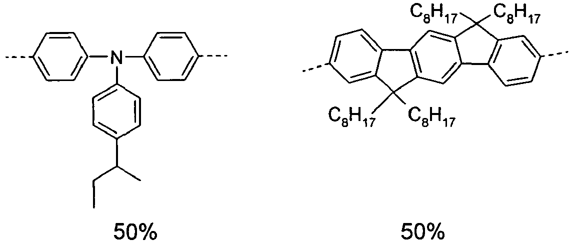

The molecular weight (MW) of the resulting polymer is distributed between 200.000 and 300.000 g/mol.

The following materials are used as emitter or host material in the emissive layer (EML). SM1 is a blue emitter and SM2 a host material. The synthesis of SM1 carried out according to WO 2008/006449A1, and that of SM2 according to JP 3148176 B2. Both SM1 and SM2 are well-soluble in toluene.

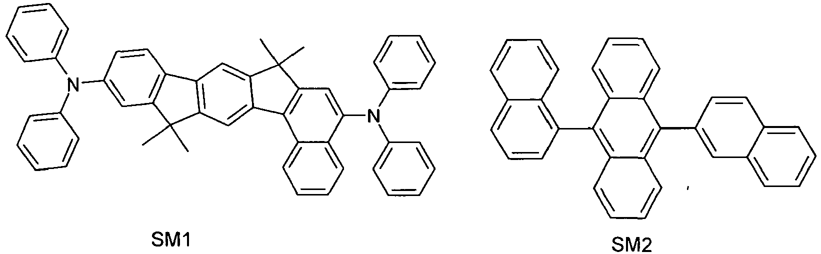

Sodium dodecyl sulfate (SDS) and PyBA are used as surfactants. PyBA can be purchased from Sigma-Aldrich, and is used as received.

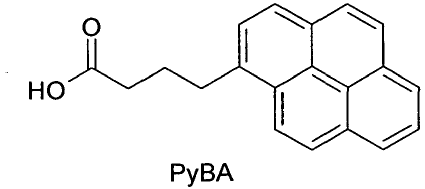

### Example 2

### Preparation of formulations (emulsions/dispersions)

In the following the preparation of mini-emulsions and dispersions comprising SM1 and SM2 is described.

Preparation of mini-emulsion E1:
a) solution 1 is formed by dissolving 285 mg of SM2 and 20 mg of SM1 in 10 g of toluene;
b) 2 g of solution1 is added to 20 g of water comprising 100 mg SDS;
c) the resulting mixture is stirred magnetically at high rate for 1 h;
d) the resulting mixture is emulsified using an ultrasonication device (Banson sonifier 450 W, 1/2-inch tip, 90% amplitude) for 4 min..

Preparation of mini-emulsion E2:
a) solution 1 is formed by dissolving 285 mg of SM2 and 20 mg of SM1 in 10 g of toluene;
b) 2 g of solution1 is added to a solution of 20 g water, 10 g DMSO and 200 mg PyBA;
c) the resulting mixture is stirred magnetically at higher rate for 1 h;
d) the resulting mixture is emulsified using an ultrasonication device (Banson sonifier 450 W, 1/2-inch tip, 90% amplitude) for 4 min..

The resulting mini-emulsions E1 and E2 are observed for at least 6 h in order to investigate stability of the mini-emulsion which is in a bottle with closed cap.

The stability of the mini-emulsions is investigated by visual inspection. A stable emulsion and dispersion is supposed to show no phase separation and precipitation within a specific time span. Both mini-emulsions E1 and E2 are stable for at least 6 h since no phase separation and precipitation can be observed.

Preparation of dispersions D1 and D2:
a) mini-emulsions E1 and E2 are prepared according to the procedure as outlined above;
b) toluene is evaporated within 3 h by keeping the bottle open and stirring the mini-emulsions

In the case of D1, the surfactant SDS, should be , at least in part, removed. This can be achieved by diafiltration (exclusion size of the membrane: 100 kDa) until a conductivity of the washing water of < 3 µS/cm is achieved. From dispersion D2 no surfactant is removed.

The diameters of the nanoparticles and its distribution can be determined via dynamic light scattering (Zeta Nanosizer (Malvern Instruments, UK). The final particle size of nanoparticles in D1 is about 55 nm in diamater, and in D2 66 nm both with approximately 20% FWHM (full width at half maximum).

### Example 3

### Preparation of a Control Device

OLED1 with a standard device structure as depicted in Figure 1 is prepared according to the following procedure:
a) Deposition of 80 nm PEDOT (Baytron P Al 4083) onto ITO coated glass substrate by spin coating;
b) Heating 10 min at 180°C at air to remove residual water;
c) Deposition of 20 nm IL1 by spin coating from toluene solution having a concentration of 0.5% wt/l in glove-box;
d) Heating the IL1 layer at 180°C for 1 h in glove-box.
e) Deposition the EML layer by spin-coating a solution of SM1 and SM2 in toluene with a concentration of 23.75 mg SM2 and 1.25 mg SM1 in 1 ml toluene to a thickness of 65 nm;
f) Heating the device at 80°C for 20 min. in the glove-box;
g) Deposition a cathode Ba/Al (3 nm/150 nm) onto the emissive layer by vacuum thermal evaporation;
h) Encapsulation of the device according to methods well known to the person skilled in the art.

### Example 4

### Preparation of OLED2

For the preparation of OLED2 a dispersion, which is prepared from a miniemulsion comprising SDS as surfactant, is employed in order to build a multilayer structure by orthogonal solvents. OLED2 is prepared according to the following procedure:
a) see step a) in Example 3;
b) see step b) in Example 3;
c) see step c) in Example 3;
d) add 20%wt iso-propanol to the dispersion D1 according to Example 2 and thoroughly stir;
e) Deposition of an EML by spin-coating the dispersion of step d) comprising the nanoparticles comprising SM1 and SM2 to a thickness of 50 to 60 nm;
f) Heating the device at 80°C for 20 min.;
g) Deposition a cathode Ba/Al (3 nm/150 nm) onto the emissive layer by vacuum thermal evaporation;
h) Encapsulation of the device according to methods well known to the person skilled in the art.

### Example 5

### Preparation of OLED3

For the preparation of OLED3 a dispersion, which is prepared from a miniemulsion comprising a functional surfactant according to the present invention, is employed in order to build a multilayer structure by orthogonal solvents. OLED3 is prepared according to the following procedure:
a) see step a) in Example 3;
b) see step b) in Example 3;
c) see step c) in Example 3;
d) add 20%wt iso-propanol to the dispersion D2 according to Example 2 and thoroughly stir;
e) Deposition of an EML by spin-coating the dispersion of step d) comprising the nano-particle comprising SM1 and SM2 to a thickness of about 65 nm;
f) Heating the device at 80°C for 20 min.;
g) Deposition a cathode Ba/AI (3 nm/150 nm) onto the emissive layer by vacuum thermal evaporation;
h) Encapsulation of the device according to methods well known to the person skilled in the art.

### Example 6

### Performance comparison

The devices OLED1-3 are investigated with respect to various physical properties employing standard methods well known to the person skilled in the art. The properties recorded are: voltage-current-luminescence (VIL) characteristics, the electroluminescence (EL) spectrum, color coordinates (CIE), efficiency, and driving voltages.

The comparison using OLED1 as control is summarized in the Table 1, wherein Uon represents the turn-on voltage, U(100) is the voltage at 100 nits (= 100 Cd/m²). The external quantum efficiency is abbreviated as EQE.

**Table 1 Performance comparison between OLED1, OLED2 and OLED3**

| Device | Max. Eff. [cd/A] | Uon [V] | U(100) [V] | CIE @ 100 cd/m² | EQE @ Max. Eff. |
|---|---|---|---|---|---|
| OLED1 | 0,80 | 5,1 | 7,2 | 0,14 / 0,18 | 0,59% |
| OLED2 | 1,52 | 5,3 | 7,9 | 0,14 / 0,17 | 1,15% |
| OLED3 | 2,47 | 5,0 | 7,0 | 0,14 / 0,19 | 1,76% |

The data in Table 1 indicate that the multilayer structure using the orthogonal solvent significantly improves the performance of OLEDs. As compared to the control device OLED1, OLED2 gives almost 2 times higher efficiency (both in Cd/A and EQE). Two possible reasons may attribute such an improvement: the first one is the thicker and well defined interlayer (IL1) by using orthogonal solvents, as shown in Example 4 and 5; the other might be due to the well-predefined nanostructure in the nano-particle.

The device according to the present invention OLED3 further improves the performance as compared to OLED2. In OLED3 the functional surfactant PyBA is used, which can also function as matrix or co-emitter. Despite removing the surfactant traces of SDS may be left in OLED2 which disturb opto-electronic properties OLED2.

## Claims

1. Emulsion for the preparation of OLEDs comprising at least one continuous phase, which comprises a first solvent selected from water, alcohols, glycols, ethers and glycol ethers, at least one discontinuous phase, which comprises a second solvent selected from organic solvents with a lower polarity than the first solvent, and at least one functional surfactant, **characterized in that** the functional surfactant has the general Formula 1, 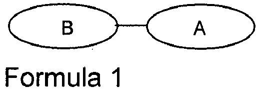 where
A is selected from the groups of Formulae 3 to 8, 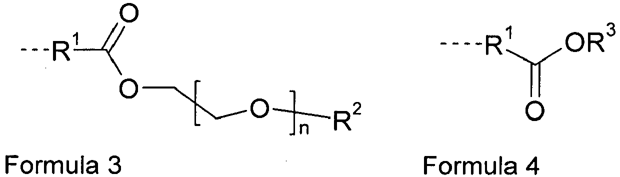 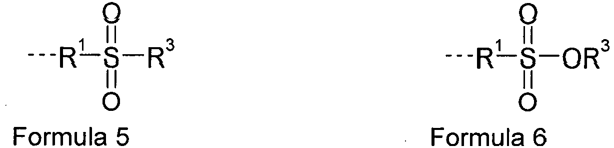 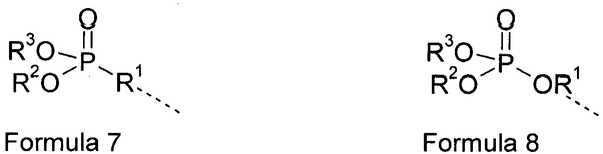
where
R¹ is a substituted or unsubstituted hydrocarbyl group having 1 to 40 C atoms, which optionally comprises one or more hetero atoms;
R², R³ are, identically or differently, selected from H, halogen, -CN,-NC, -NCO, -NCS, -OCN, -SCN, -C(=O)NR⁰R⁰⁰, -C(=O)X,-C(=O)RO⁰, -NH₂, -NR⁰R⁰⁰, -SH, -SR⁰, -SO₃H, -SO₂R⁰, -OH,-NO₂, -CF₃, -SF₅, optionally substituted with hydrocarbyl having 1 to 6 C atoms, optionally comprising one or more hetero atoms;
R⁰ and R⁰⁰ are independently of each other H or an optionally substituted hydrocarbyl group, optionally comprising one or more hetero atoms; and
n is equal or larger than 1;
B is a functional group, wherein the functional group is selected from host groups selected from oligoarylenes containing naphthalene, anthracene, benzanthracene and/or pyrene;
and wherein the emulsion comprises in the discontinuous phase at least one further organic functional material selected from host materials, hole injection materials (HIM), hole transport materials (HTM), hole blocking materials (HBM), electron injection materials (EIM), electron transport materials (ETM), electron blocking materials (EBM), exciton blocking materials (ExBM), photoabsorption materials, dyes, and metal complexes,
and wherein the discontinuous phase(s) form(s) nanodroplets.

2. Emulsion according to claim 1, **characterized in that** the nanodroplets have an average diameter in the range of 1 to 7000 nm.

3. Emulsion according to claim 1 or 2, **characterized in that** the discontinuous phase(s) form(s) nanodroplets wherein more than 75% of the nanodroplets have an average diameter that deviates from the mean of all average diameters of the nanodroplets by 55% or less.

4. Emulsion according to one or more of claims 1 to 3, **characterized in that** the discontinuous phase(s) comprise(s) at least one further functional material selected from emissive materials and metal complexes.

5. Emulsion according to one or more of claims 1 to 4, **characterized in that** it comprises at least two further functional materials selected from emitter materials wherein the emitter materials are independently from each other selected from fluorescent materials and phosphorescent materials.

6. Method for the preparation of an emulsion according to one or more of claims 1 to 5 comprising the following steps:
(a) preparing a first solution comprising at least one first further functional material in at least one first solvent, and at least one functional surfactant;
(b) preparing a second solution comprising said at least one second functional material in at least one second solvent;
(c) mixing the first solution obtained in step (a) and the second solution obtained in step b) in a specific ratio;
(d) forming an emulsion from the mixture obtained in step (c) by ultrasonication.

7. Method for the preparation of an emulsion according to one or more of claims 1 to 5, **characterized in that** the solvent of at least one discontinuous phase of the emulsion obtained by a method according to claim 6 is removed and if a further non-functional surfactant is present in the emulsion it is, at least in part, removed.

8. Method for the preparation of a multi layer structure comprising the following steps:
(a) applying a first layer on a substrate;
(b) applying a second layer to the first layer by coating the emulsion according to one or more of claims 1 to 5,
**characterised in that** the first layer is insoluble or has a limited solubility, preferably less than 0.4 wt% at the working temperature in the solvent of the continuous phase of said emulsion.

9. Method for the preparation of a layer structure comprising following steps:
(a) applying a first layer on a substrate by coating the emulsion according to one or more of claims 1 to 5;
(b) applying a second layer to the first layer from an additional emulsion according to one or more of claims 1 to 5;
**characterised in that** the functional material in the first layer is insoluble or has a limited solubility of ≤ 0.4 wt% at the working temperature in the solvent of the continuous phase of the additional emulsion.

10. Method according to claim 8 or 9, **characterized in that** the at least one additive is added to the emulsion.

11. Use of an emulsion according to one or more of claims 1 to 5 for the preparation of electronic and opto-electronic devices.

12. Use of a method according to one or more of claims 8 to 10 for the preparation of electronic and opto-electronic devices.

13. Use according to claim 11 or 12, **characterized in that** the device is selected from organic light emitting diodes (OLEDs), polymer light emitting diodes (PLEDs), fiber OLEDs, organic light emitting electrochemical cells (OLECs), organic field effect transistors (OFETs), thin film transistors (TFTs), organic solar cells (O-SCs), dye-sensitised solar cells (DSSCs), organic laser diodes (O-laser), organic integrated circuits (O-IC), radio frequency identification (RFID) tags, photodetectors, sensors, logic circuits, memory elements, capacitors, charge injection layers, Schottky diodes, planarising layers, antistatic films, conducting substrates or patterns, photoconductors, electrophotographic elements, organic light emitting transistors (OLETs), organic spintronic devices, and organic plasmon emitting devices (OPEDs).

14. Layer obtainable by the use of an emulsion according to one or more of claims 1 to 5.

15. Device comprising a layer according to claim 14.

16. Use of a device according to claim 15 for the application in lightening, in display applications, and for cosmetic applications.

17. Device according to claim 15 for the use in medicine with photo-therapy

## Patentansprüche

1. Emulsion zur Herstellung von OLEDs, enthaltend mindestens eine kontinuierliche Phase, die ein erstes aus Wasser, Alkoholen, Glykolen, Ethern und Glykolethern ausgewähltes Lösungsmittel enthält, mindestens eine diskontinuierliche Phase, die ein zweites aus organischen Lösungsmitteln mit einer niedrigeren Polarität als das erste Lösungsmittel ausgewähltes Lösungsmittel enthält, und mindestens ein funktionelles Tensid, **dadurch gekennzeichnet, dass** das funktionelle Tensid die allgemeine Formel 1 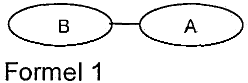 besitzt, worin
A aus den Gruppen der Formeln 3 bis 8 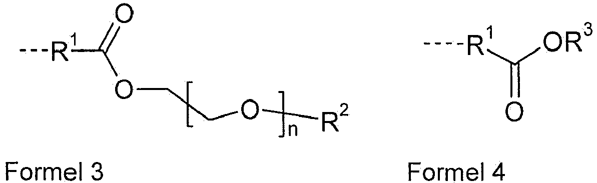 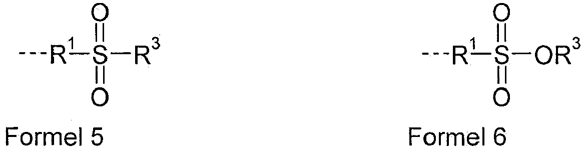 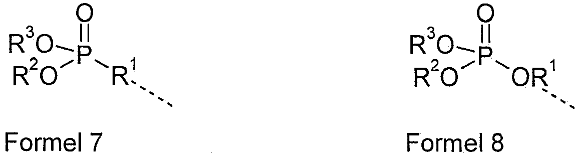
ausgewählt ist, worin
R¹ eine substituierte oder unsubstituierte Hydrocarbylgruppe mit 1 bis 40 C-Atomen ist, die gegebenenfalls ein oder mehrere Heteroatome enthält;
R², R³ gleich oder verschieden aus H, Halogen, -CN, -NC, -NCO, -NCS, -OCN, -SCN, -C(=O)NR⁰R⁰⁰, -C(=O)X, -C(=O)R⁰, -NH2, -NR⁰R⁰⁰, -SH, -SR⁰, -SO₃H, -SO2R⁰, -OH, -NO2, -CF₃, -SF₅, gegebenenfalls substituiert mit Hydrocarbyl mit 1 bis 6 C-Atomen, gegebenenfalls enthaltend ein oder mehrere Heteroatome, ausgewählt sind;
R⁰ und R⁰⁰ unabhängig voneinander H oder eine gegebenenfalls substituierte Hydrocarbylgruppe, gegebenenfalls enthaltend ein oder mehrere Heteroatome, sind, und
n gleich oder größer als 1 ist;
B eine funktionelle Gruppe ist, wobei die funktionelle Gruppe aus Host-Gruppen ausgewählt ist, die aus Oligoarylenen enthaltend Naphthalin, Anthracen, Benzanthracen und/oder Pyren ausgewählt sind;
und wobei die Emulsion in der diskontinuierlichen Phase mindestens ein weiteres organisches funktionelles Material enthält, das aus Host-Materialien, Lochinjektionsmaterialien (HIM), Lochtransportmaterialien (HTM), Lochblockiermaterialien (HBM), Elektroneninjektionsmaterialien (EIM), Elektronentransportmaterialien (ETM), Elektronenblockiermaterialien (EBM), Exzitonenblockiermaterialien (ExBM), Photoabsorptionsmaterialien, Farbstoffen und Metallkomplexen ausgewählt ist,
und worin die diskontinuierliche Phase(n) Nanotröpfchen bildet/ bilden.

2. Emulsion nach Anspruch 1, **dadurch gekennzeichnet, dass** die Nanotröpfchen einen durchschnittlichen Durchmesser im Bereich von 1 bis 7000 nm aufweisen.

3. Emulsion nach Anspruch 1 oder 2, **dadurch gekennzeichnet, dass** die diskontinuierliche Phase(n) Nanotröpfchen bildet/bilden, wobei mehr als 75% der Nanotröpfchen einen durchschnittlichen Durchmesser aufweisen, der vom Mittelwert aller durchschnittlichen Durchmesser der Nanotröpfchen um 55% oder weniger abweicht.

4. Emulsion nach einem oder mehreren der Ansprüche 1 bis 3, **dadurch gekennzeichnet, dass** die diskontinuierliche Phase(n) mindestens ein weiteres, aus emittierenden Materialien und Metallkomplexen ausgewähltes funktionelles Material enthält/enthalten.

5. Emulsion nach einem oder mehreren der Ansprüche 1 bis 4, **dadurch gekennzeichnet, dass** sie mindestens zwei weitere, aus Emittermaterialien ausgewählte funktionelle Materialien enthält, wobei denen die Emittermaterialien unabhängig voneinander aus Fluoreszenzmaterialien und Phosphoreszenzmaterialien ausgewählt sind.

6. Verfahren zur Herstellung einer Emulsion nach einem oder mehreren der Ansprüche 1 bis 5, umfassend die folgenden Schritte:
(a) Herstellen einer ersten Lösung enthaltend mindestens ein erstes weiteres funktionelles Material in mindestens einen ersten Lösungsmittel und mindestens ein funktionelles Tensid;
(b) Herstellen einer zweiten Lösung enthaltend das mindestens eine zweite funktionelle Material in mindestens einem zweiten Lösungsmittel;
(c) Mischen der ersten in Schritt (a) erhaltenen Lösung und der zweiten in Schritt b) erhaltenen Lösung in einem spezifischen Verhältnis;
(d) Bilden einer Emulsion aus der in Schritt (c) erhaltenen Mischung durch Ultraschallbehandlung.

7. Verfahren zur Herstellung einer Emulsion nach einem oder mehreren der Ansprüche 1 bis 5, **dadurch gekennzeichnet, dass** das Lösungsmittel mindestens einer diskontinuierlichen Phase der nach einem Verfahren nach Anspruch 6 erhaltenen Emulsion entfernt wird und, wenn ein weiteres nicht funktionelles Tensid in der Emulsion vorhanden ist, dieses zumindest teilweise entfernt wird.

8. Verfahren zur Herstellung einer Mehrschichtstruktur umfassend die folgenden Schritte:
(a) Aufbringen einer ersten Schicht auf ein Substrat;
(b) Aufbringen einer zweiten Schicht auf die erste Schicht durch Auftragen der Emulsion nach einem oder mehreren der Ansprüche 1 bis 5,
**dadurch gekennzeichnet, dass** die erste Schicht in dem Lösungsmittel der kontinuierlichen Phase der Emulsion unlöslich ist oder eine begrenzte Löslichkeit besitzt, vorzugsweise weniger als 0,4 Gew.-% bei der Arbeitstemperatur.

9. Verfahren zur Herstellung einer Schichtstruktur umfassend die folgenden Schritte:
(a) Aufbringen einer ersten Schicht auf ein Substrat durch Auftragen der Emulsion nach einem oder mehreren der Ansprüche 1 bis 5;
(b) Aufbringen einer zweiten Schicht auf die erste Schicht aus einer zusätzlichen Emulsion nach einem oder mehreren der Ansprüche 1 bis 5;
**dadurch gekennzeichnet, dass** das funktionelle Material in der ersten Schicht in dem Lösungsmittel der kontinuierlichen Phase der zusätzlichen Emulsion unlöslich ist oder eine begrenzte Löslichkeit von ≤ 0,4 Gew.-% bei der Arbeitstemperatur besitzt.

10. Verfahren nach Anspruch 8 oder 9, **dadurch gekennzeichnet, dass** der mindestens eine Zusatzstoff zu der Emulsion hinzugegeben wird.

11. Verwendung einer Emulsion nach einem oder mehreren der Ansprüche 1 bis 5 für die Herstellung von elektronischen und optoelektronischen Vorrichtungen.

12. Verwendung eines Verfahrens nach einem oder mehreren der Ansprüche 8 bis 10 für die Herstellung von elektronischen und optoelektronischen Vorrichtungen.

13. Verwendung nach Anspruch 11 oder 12, **dadurch gekennzeichnet, dass** die Vorrichtung aus organischen Leuchtdioden (organic light emitting diodes - OLEDs), Polymer-Leuchtdioden (polymer light emitting diodes - PLEDs), Faser-OLEDs, organischen lichtemittierenden elektrochemischen Zellen (organic light emitting electrochemical cells - OLECs), organischen Feldeffekttransistoren (organic field effect transistors - OFETs), Dünnschichttransistoren (thin film transistors - TFTs), organischen Solarzellen (organic solar cells - O-SCs), farbstoffsensibilisierten Solarzellen (dye-sensitised solar cells - DSSCs), organischen Laserdioden (organic laser diodes - O-laser), organischen integrierten Schaltungen (organic integrated circuits - O-IC), RFID-Tags (RFID - radio frequency identification), Photodetektoren, Sensoren, logischen Schaltungen, Speicherelementen, Kondensatoren, Ladungsinjektionsschichten, Schottky-Dioden, Planarisierungsschichten, Antistatikfolien, leitenden Substraten oder Strukturen, Photoleitern, elektrophotographischen Elementen, organischen lichtemittierenden Transistoren (organic light emitting transistors - OLETs), organischen Spintronic-Vorrichtungen und organischen Plasmon-emittierenden Vorrichtungen (organic plasmon emitting devices - OPEDs) ausgewählt ist.

14. Schicht erhältlich durch Verwendung einer Emulsion nach einem oder mehreren der Ansprüche 1 bis 5.

15. Vorrichtung enthaltend eine Schicht nach Anspruch 14.

16. Verwendung einer Vorrichtung nach Anspruch 15 zur Anwendung beim Aufhellen, in Anzeigeanwendungen und für kosmetische Anwendungen.

17. Vorrichtung nach Anspruch 15 zur Verwendung in der Medizin mit Phototherapie.

## Revendications

1. Emulsion pour la préparation d'OLED, comprenant au moins une phase continue, laquelle comprend un premier solvant qui est sélectionné parmi l'eau, les alcools, les glycols, les éthers et les éthers de glycol, au moins une phase discontinue, laquelle comprend un second solvant qui est sélectionné parmi les solvants organiques présentant une polarité inférieure à celle du premier solvant, et au moins un agent tensioactif fonctionnel, **caractérisée en ce que** l'agent tensioactif fonctionnel présente la Formule générale 1 : 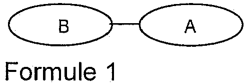 dans laquelle :
A est sélectionné parmi les groupes des Formules 3 à 8 : 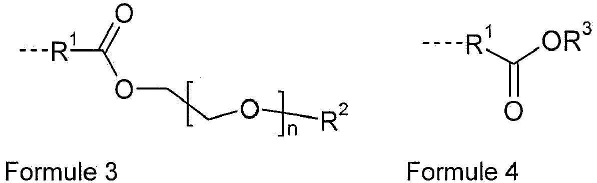 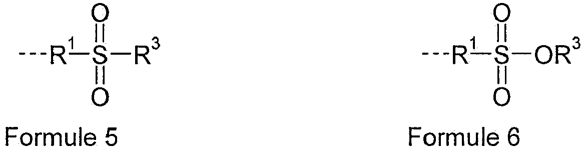 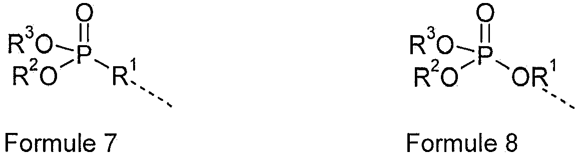
dans lesquelles :
R¹ est un groupe hydrocarbyle substitué ou non substitué qui comporte de 1 à 40 atome(s) de C, lequel comprend en option un ou plusieurs hétéroatome(s) ;
R², R³ sont, de manière identique ou différente, sélectionnés parmi H, halogène, -CN, -NC, -NCO, -NCS, -OCN, -SCN, -C(=O)NR⁰R⁰⁰, -C(=O)X, -C(=O)R⁰, -NH₂, -NR⁰R⁰⁰, -SH, -SR⁰, -SO₃H, -SO₂R⁰, -OH, -NO₂, -CF₃, -SF₅, en option substitués avec hydrocarbyle qui comporte de 1 à 6 atome(s) de C, comprenant en option un ou plusieurs hétéroatome(s) ;
R⁰ et R⁰⁰ sont, de manière indépendante l'un de l'autre, H ou un groupe hydrocarbyle en option substitué, comprenant en option un ou plusieurs hétéroatome(s) ; et
n est égal ou supérieur à 1 ;
B est un groupe fonctionnel, où le groupe fonctionnel est sélectionné parmi des groupes hôtes qui sont sélectionnés parmi les oligoarylènes qui contiennent du naphtalène, de l'anthracène, du benzanthracène et/ou du pyrène ;
et dans laquelle l'émulsion comprend, dans la phase discontinue, au moins un autre matériau fonctionnel organique qui est sélectionné parmi les matériaux hôtes, les matériaux d'injection de trous (HIM), les matériaux de transport de trous (HTM), les matériaux de blocage de trous (HBM), les matériaux d'injection d'électrons (EIM), les matériaux de transport d'électrons (ETM), les matériaux de blocage d'électrons (EBM), les matériaux de blocage d'excitons (ExBM), les matériaux de photo-absorption, les colorants, et les complexes métalliques ;
et où la/les phase(s) discontinue(s) forme(nt) des nano-gouttelettes.

2. Emulsion selon la revendication 1, **caractérisée en ce que** les nano-gouttelettes présentent un diamètre moyen dans la plage de 1 à 7000 nm.

3. Émulsion selon la revendication 1 ou 2, **caractérisée en ce que** la/les phase(s) discontinue(s) forme(nt) des nano-gouttelettes, où plus de 75 % des nano-gouttelettes présentent un diamètre moyen qui s'écarte de la moyenne de tous les diamètres moyens des nano-gouttelettes de 55% ou moins.

4. Emulsion selon une ou plusieurs des revendications 1 à 3, **caractérisée en ce que** la/les phase(s) discontinue(s) comprend/comprennent au moins un autre matériau fonctionnel qui est sélectionné parmi les matériaux émissifs et les complexes métalliques.

5. Emulsion selon une ou plusieurs des revendications 1 à 4, **caractérisée en ce qu'**elle comprend au moins deux autres matériaux fonctionnels qui sont sélectionnés parmi les matériaux d'émetteur, où les matériaux d'émetteur sont, de manière indépendante les uns des autres, sélectionnés parmi les matériaux fluorescents et les matériaux phosphorescents.

6. Procédé pour la préparation d'une émulsion selon une ou plusieurs des revendications 1 à 5, comprenant les étapes qui suivent :
(a) la préparation d'une première solution qui comprend au moins un premier autre matériau fonctionnel dans au moins un premier solvant, et au moins un agent tensioactif fonctionnel ;
(b) la préparation d'une seconde solution qui comprend ledit au moins un second matériau fonctionnel dans au moins un second solvant ;
(c) le mélange de la première solution qui est obtenue au niveau de l'étape (a) et de la seconde solution qui est obtenue au niveau de l'étape (b) selon un rapport spécifique ; et
(d) la formation d'une émulsion à partir du mélange qui est obtenu au niveau de l'étape (c) par sonication aux ultrasons.

7. Procédé pour la préparation d'une émulsion selon une ou plusieurs des revendications 1 à 5, **caractérisé en ce que** le solvant d'au moins une phase discontinue de l'émulsion qui est obtenue au moyen d'un procédé selon la revendication 6 est enlevé et si un autre agent tensioactif non fonctionnel est présent dans l'émulsion, il est, au moins en partie, enlevé.

8. Procédé pour la préparation d'une structure à multiples couches, comprenant les étapes qui suivent :
(a) l'application d'une première couche sur un substrat ;
(b) l'application d'une seconde couche sur la première couche en déposant par revêtement l'émulsion selon une ou plusieurs des revendications 1 à 5 ;
**caractérisé en ce que** la première couche est insoluble ou présente une solubilité limitée, de préférence inférieure à 0,4 % en poids à la température de traitement dans le solvant de la phase continue de ladite émulsion.

9. Procédé pour la préparation d'une structure de couches, comprenant les étapes qui suivent :
(a) l'application d'une première couche sur un substrat en déposant par revêtement l'émulsion selon une ou plusieurs des revendications 1 à 5 ;
(b) l'application d'une seconde couche sur la première couche à partir d'une émulsion additionnelle selon une ou plusieurs des revendications 1 à 5 ;
**caractérisé en ce que** le matériau fonctionnel dans la première couche est insoluble ou présente une solubilité limitée ≤ 0,4 % en poids à la température de traitement dans le solvant de la phase continue de l'émulsion additionnelle.

10. Procédé selon la revendication 8 ou 9, **caractérisé en ce que** l'au moins un additif est ajouté à l'émulsion.

11. Utilisation d'une émulsion selon une ou plusieurs des revendications 1 à 5 pour la préparation de dispositifs électroniques et optoélectroniques.

12. Utilisation d'un procédé selon une ou plusieurs des revendications 8 à 10 pour la préparation de dispositifs électroniques et optoélectroniques.

13. Utilisation selon la revendication 11 ou 12, **caractérisée en ce que** le dispositif est sélectionné parmi les diodes émettrices de lumière organiques (OLED), les diodes à émission de lumière à polymère (PLED), les OLED à fibre, les cellules électrochimiques à émission de lumière organiques (OLEC), les transistors à effet de champ organiques (OFET), les transistors à film mince (TFT), les cellules solaires organiques (O-SC), les cellules solaires sensibilisées par colorant(s) (DSSC), les diodes laser organiques (O-laser), les circuits intégrés organiques (O-IC), les étiquettes d'identification radiofréquence (RFID), les photodétecteurs, les capteurs, les circuits logiques, les éléments de mémoire, les condensateurs, les couches d'injection de charges, les diodes Schottky, les couches de planarisation, les films antistatiques, les substrats ou motifs de conduction, les photoconducteurs, les éléments électrophotographiques, les transistors à émission de lumière organiques (OLET), les dispositifs spintroniques organiques, et les dispositifs à émission de plasmons organiques (OPED).

14. Couche pouvant être obtenue au moyen de l'utilisation d'une émulsion selon une ou plusieurs des revendications 1 à 5.

15. Dispositif comprenant une couche selon la revendication 14.

16. Utilisation d'un dispositif selon la revendication 15 pour son application au niveau de l'éclairage, dans des applications d'affichage et pour des applications cosmétiques.

17. Dispositif selon la revendication 15 pour son utilisation en médecine en lien avec la photothérapie.
